(19) Europäisches Patentamt
European Patent Office
Office européen des brevets

(11) **EP 4 637 031 A1**

(12) **EUROPEAN PATENT APPLICATION**
published in accordance with Art. 153(4) EPC

(43) Date of publication:
**22.10.2025 Bulletin 2025/43**

(21) Application number: **23917205.9**

(22) Date of filing: **23.11.2023**

(51) International Patent Classification (IPC):
*H03H 9/17* (2006.01)

(52) Cooperative Patent Classification (CPC):
**H03H 9/02; H03H 9/13; H03H 9/17; H03H 9/215;
H03H 9/54; H03H 9/70**

(86) International application number:
**PCT/CN2023/133797**

(87) International publication number:
**WO 2024/152737 (25.07.2024 Gazette 2024/30)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 20.01.2023 CN 202310202885
28.04.2023 CN 202310490983
31.05.2023 CN 202310639000

(71) Applicant: **Huawei Technologies Co., Ltd.
Shenzhen, Guangdong 518129 (CN)**

(72) Inventors:
• **ZHANG, Naiqing
Shenzhen, Guangdong 518129 (CN)**
• **PLESSKI, Viktor
Shenzhen, Guangdong 518129 (CN)**

(74) Representative: **Maiwald GmbH
Engineering
Elisenhof
Elisenstrasse 3
80335 München (DE)**

(54) **RESONATOR, FILTER, AND ELECTRONIC DEVICE**

(57)    This application provides a resonator, a filter, and an electronic device, and relates to the field of resonator technologies. The resonator includes a substrate, a first electrode, a piezoelectric layer, and a plurality of second electrodes. The plurality of second electrodes are arranged side by side. The piezoelectric layer includes a piezoelectric material and is disposed between the first electrode and the plurality of second electrodes. The resonator may excite, by using a vertical electric field, the piezoelectric layer to generate resonance.

[FIG. 8A]

**Description**

This application claims priorities to Chinese Patent Application No. 202310202885.2, filed with the China National Intellectual Property Administration on January 20, 2023 and entitled "RESONATOR, FILTER, AND MANUFACTURING METHOD THEREOF", to Chinese Patent Application No. 202310490983.0, filed with the China National Intellectual Property Administration on April 28, 2023 and entitled "ACOUSTIC RESONATOR, FILTER, AND ELECTRONIC DEVICE", and to Chinese Patent Application No. 202310639000.5, filed with the China National Intellectual Property Administration on May 31, 2023 and entitled "RESONATOR, FILTER, AND ELECTRONIC DEVICE", all of which are incorporated herein by reference in their entireties.

TECHNICAL FIELD

This application relates to the field of resonator technologies, and relates to a resonator, a filter having a resonator, and an electronic device including a filter or a resonator.

BACKGROUND

With development of communication technologies, a quantity of resonators needed for an electronic device significantly increases. For example, bulk acoustic resonators such as a horizontally-excited bulk acoustic resonator (Horizontally-excited Bulk Acoustic Resonator, XBAR), a vertically-excited bulk acoustic resonator (Vertically-excited Bulk Acoustic Resonator, YBAR), and a film bulk acoustic resonator (Film Bulk Acoustic Resonator, FBAR) have attracted wide attention.

The YBAR has a larger electromechanical coupling factor and a more efficient resonance mode, and may be applied to higher passband bandwidth, for example, may satisfy passband bandwidth of a sub-6 GHz frequency band.

However, in a current YBAR, many different types of spurious modes appear near a resonance frequency range and an anti-resonance frequency range of the YBAR. The spurious modes interfere with a main resonance mode to a large extent, and cause many problems to performance of a resonator and a filter. For example, the spurious modes cause an increase in passband ripples of the filter and deterioration of out-of-band suppression performance of the filter.

SUMMARY

This application provides a resonator, a filter having a resonator, and an electronic device including a filter. A main objective is to provide a resonator that not only has a large electromechanical coupling factor but also can effectively suppress a parasitic spurious mode.

To achieve the foregoing objective, the following technical solutions are used in embodiments of this application.

According to an aspect, this application provides a resonator. In an embodiment, the resonator may be an acoustic resonator, for example, a YBAR.

The resonator includes a substrate, a first electrode, a piezoelectric layer, and a plurality of second electrodes. The plurality of second electrodes are arranged side by side along a first direction. The piezoelectric layer has a first side and a second side, the plurality of second electrodes are located on the first side, and the first electrode and the substrate are located on the second side. That is, the piezoelectric layer is stacked between the first electrode and the second electrodes. In this way, the piezoelectric layer is excited by a vertical electric field formed between the first electrode and the second electrodes to generate resonance, for example, form a YBAR. In addition, in the resonator in this application, the piezoelectric layer includes a piezoelectric material. A crystal cutting angle and a propagation direction of the piezoelectric material are X-cut and a (120°±30°) Y propagation direction, or a Euler angle of a crystal of the piezoelectric material is (90°, 90°, 120°±30°), where an X direction of the piezoelectric material and a thickness direction of the piezoelectric layer are a same direction, and the (120°±30°) Y direction of the piezoelectric material and the first direction are a same direction. Alternatively, a crystal cutting angle and a propagation direction of the piezoelectric material are Y-cut and a (90°±30°) X propagation direction, or a Euler angle of a crystal of the piezoelectric material is (0°, 90°, 90°±30°), where a Y direction of the piezoelectric material and a thickness direction of the piezoelectric layer are a same direction, and the (90°±30°) X direction of the piezoelectric material and the first direction are a same direction.

In the resonator in this application, the crystal cutting angle and the propagation direction of the piezoelectric material may be X-cut and the (120°±30°) Y propagation direction, in other words, the Euler angle may be (90°, 90°, 120°±30°); or the crystal cutting angle and the propagation direction may be Y-cut and the (90°±30°) X propagation direction, in other words, the Euler angle may be (0°, 90°, 90°±30°). According to the resonator structure in this application, the resonator can have a large electromechanical coupling factor under this limitation of the Euler angle. For example, the electromechanical coupling factor may be greater than 40%.

In addition, in the resonator structure, an electromechanical coupling factor component $k_{35}^2$ is greater than 0.4, and may be excited to generate a first-order anti-symmetry main resonance mode A1. For electromechanical coupling factor components, such as $k_{21}^2$, $k_{22}^2$, $k_{23}^2$, $k_{24}^2$, $k_{25}^2$, and $k_{26}^2$, with large values other than the electromechanical coupling factor component $k_{35}^2$, a direction of an electric field for exciting the electromechanical coupling factor components is parallel to an extension direction of the second electrodes. In addition, along the extension direction of the second electrodes, potentials on the second electrodes are the same, and electric field strength is zero. Therefore, electromechanical coupling factor components $k_{22}^2$, $k_{26}^2$, $k_{24}^2$, and $k_{32}^2$ cause a small parasitic spurious mode, so that performance of the entire resonator is optimized.

In a feasible implementation, a first spacing is provided between two adjacent second electrodes, a first groove is provided at a position, facing the first spacing, on the piezoelectric layer, and the first groove communicates with the first spacing.

Because the groove is formed on the piezoelectric layer, the groove helps further suppress or frequency-shift a parasitic spurious mode, and increase the electromechanical coupling factor of the resonator.

In a feasible implementation, the piezoelectric layer has a bottom surface located on the second side and a top surface located on the first side, and the first groove communicates with the bottom surface and the top surface.

Because the groove passes through the piezoelectric layer from the top surface to the bottom surface, the electromechanical coupling factor can be further increased.

In a feasible implementation, from the top surface to the bottom surface, a radial size of the first groove gradually increases.

For example, a tilt angle $\alpha$ of a side surface of the first groove meets: $45° < \alpha < 90°$, or $60° < \alpha < 90°$.

In a feasible implementation, the resonator further includes a protective layer. Surfaces, away from the piezoelectric layer, of the second electrodes, a side surface of the first spacing, and the side surface and a bottom surface of the first groove are all covered by the protective layer.

The protective layer may protect the resonator from impact of corrosion, scratches, oxidation, or the like, and protect performance of the device. In addition, the protective layer may also adjust a resonance frequency of the resonator, and may further adjust the electromechanical coupling factor and a temperature coefficient (Temperature coefficient of frequency, TCF) of the resonator.

In a feasible implementation, the first electrode has a first surface and a second surface that are opposite to each other, the first surface is closer to the piezoelectric layer than the second surface, the substrate is provided with a cavity, at least a part of the second surface of the first electrode is used to enclose the cavity, and at least a part of the first electrode is disposed between the cavity and the piezoelectric layer.

In a feasible implementation, the electromechanical coupling factor $K_t^2$ of the resonator is greater than or equal to 20%.

The resonator formed in this way may be referred to as a suspended cavity resonator. In the resonator of this structure, because the electromechanical coupling factor component $k_{35}^2$ is greater than 0.4, the electromechanical coupling factor of the resonator may reach 20% or above.

In a feasible implementation, the resonator further includes a first busbar and a second busbar. One of every two adjacent second electrodes among the plurality of second electrodes is a first interdigital electrode, and the other is a second interdigital electrode. The first interdigital electrode and the second interdigital electrode are spaced apart along the first direction. An extension direction of the first interdigital electrode and/or an extension direction of the second interdigital electrode are/is perpendicular to the first direction. A plurality of first interdigital electrodes among the plurality of second electrodes are connected through the first busbar. A plurality of second interdigital electrodes among the plurality of second electrodes are connected through the second busbar. A pitch P and a thickness d of the piezoelectric layer meet: $P/d \geq 0.5$. A width dimension of each first interdigital electrode is s1, a spacing between each first interdigital electrode and each second interdigital electrode that are adjacent to each other is s2, and the pitch P is equal to s1+s2. The width dimension is a dimension parallel to a surface of the substrate and perpendicular to the extension direction of the first interdigital electrode.

In the suspended cavity resonator, when the pitch P and the thickness d of the piezoelectric layer meet the condition of $P/d \geq 0.5$, the electromechanical coupling factor of the resonator can be further increased.

In a feasible implementation, the first electrode has a first surface and a second surface that are opposite to each other, the first surface is closer to the piezoelectric layer than the second surface, the first electrode is disposed between the substrate and the piezoelectric layer, and the second surface of the first electrode is completely provided on the substrate.

In a feasible implementation, the electromechanical coupling factor $K_t^2$ of the resonator is greater than or equal to 10%.

The resonator formed in this way may be referred to as a solid-state substrate resonator. In the resonator of this structure, because the electromechanical coupling factor component $k_{35}^2$ is greater than 0.4, the electromechanical coupling factor of the resonator may reach 10% or above.

In a feasible implementation, the solid-state substrate resonator further includes: The resonator further includes a first busbar and a second busbar. One of every two adjacent second electrodes among the plurality of second electrodes is a first interdigital electrode, and the other is a second interdigital electrode. The first interdigital electrode and the second interdigital electrode are spaced apart along the first direction. An extension direction of the first interdigital electrode and/or an extension direction of the second interdigital electrode are/is perpendicular to the first direction. A plurality of first interdigital electrodes among the plurality of second electrodes are connected through the first busbar. A plurality of second interdigital electrodes among the plurality of second electrodes are connected through the second busbar. A pitch P meets: $P < \frac{Vs}{2f}$, where Vs is a shear bulk acoustic wave velocity of the substrate, and f is an operating frequency of the resonator. A width dimension of each first interdigital electrode is s1, a spacing between each first interdigital electrode and each second interdigital electrode that are adjacent to each other is s2, the pitch P is equal to s1+s2. The width dimension is a dimension parallel to a surface of the substrate and perpendicular to the extension direction of the first interdigital electrode.

When the pitch P meets the condition of $P < \frac{Vs}{2f}$, energy leakage from the piezoelectric layer to a substrate layer can be prevented, to increase a value of a quality factor Q and the electromechanical coupling factor.

In a feasible implementation, the substrate includes at least one of silicon carbide, boron nitride, and diamond.

In a feasible implementation, a thickness dimension Z of the substrate meets: $Z \geq 4d$, where d is a thickness dimension of the piezoelectric layer, and both the thickness dimension of the substrate and the thickness dimension of the piezoelectric layer are dimensions along a direction perpendicular to the surface of the substrate.

In this way, the value of the quality factor Q and the electromechanical coupling factor can be further increased.

In a feasible implementation, the solid-state substrate resonator further includes a first reflection layer and a second reflection layer that are stacked. The first reflection layer and the second reflection layer are disposed between the substrate and the first electrode. A thickness t1 of the first reflection layer meets: $\frac{1}{8}\lambda_1 \leq t1 \leq \frac{3}{8}\lambda_1$; and a thickness t2 of the second reflection layer meets: $\frac{1}{8}\lambda_2 \leq t2 \leq \frac{3}{8}\lambda_2$, where $\lambda_1$ is a wavelength of an acoustic wave of the resonator at a resonance frequency in a material of the first reflection layer, and $\lambda_2$ is a wavelength of the acoustic wave in a material of the second reflection layer.

The first reflection layer and the second reflection layer that are stacked may be considered as a group. In some examples, three groups to ten groups may be disposed.

In a feasible implementation, a dielectric layer is stacked between the substrate and the first electrode, and a thickness g of the dielectric layer meets: $g=\lambda/4$, where $\lambda$ is a wavelength of the acoustic wave of the resonator at the resonance frequency in a material of the dielectric layer.

The dielectric layer is disposed between the substrate and the first electrode to prevent coupling between the piezoelectric layer and the substrate, so that the electromechanical coupling factor of the device can be increased. In addition, when the thickness g of the dielectric layer meets the condition of $g=\lambda/4$, the electromechanical coupling factor can be further increased.

In a feasible implementation, the resonator further includes a first busbar and a second busbar. One of every two adjacent second electrodes among the plurality of second electrodes is a first interdigital electrode, and the other is a second interdigital electrode. The first interdigital electrode and the second interdigital electrode are spaced apart along the first direction. An extension direction of the first interdigital electrode and/or an extension direction of the second interdigital electrode are/is perpendicular to the first direction. A plurality of first interdigital electrodes among the plurality of second electrodes are connected through the first busbar. A plurality of second interdigital electrodes among the plurality of second electrodes are connected through the second busbar. A pitch P and a thickness d of the piezoelectric layer meet: $P/d \geq 1$. A width dimension of each first interdigital electrode is s1, a spacing between each first interdigital electrode and each second interdigital electrode that are adjacent to each other is s2, and the pitch P is equal to s1+s2. The width dimension is a dimension parallel to a surface of the substrate and perpendicular to the extension direction of the first interdigital electrode.

When the pitch P and the thickness d of the piezoelectric layer meet the condition of $P/d \geq 1$, the electromechanical coupling factor of the resonator can be further increased. For example, the electromechanical coupling factor of the resonator can reach 45%.

In a feasible implementation, $30 \geq P/d \geq 1$, or $20 \geq P/d \geq 1$, or $10 \geq P/d \geq 1$.

In a feasible implementation, the resonator further includes a conductive connection layer, and the conductive connection layer is stacked between the first electrode and the piezoelectric layer.

In this way, connection strength between the first electrode and the piezoelectric layer can be increased. This avoids poor adhesion between layers that is caused by a mismatch between a lattice of the first electrode and a lattice of the piezoelectric layer and that affects device firmness.

In a feasible implementation, at least a part of the plurality of second electrodes include a first end portion and a second end portion, a thickness dimension D1 of the first end portion is greater than a thickness dimension D2 of the second end portion, and 120%≤D1/D2≤300%.

When 120%≤D1/D2≤300%, a transverse mode may be suppressed.

In a feasible implementation, at least a part of the plurality of second electrodes include a first end portion and a second end portion, a width dimension h1 of the first end portion is greater than a width dimension h2 of the second end portion, and 100%<h1/h2≤200%. The width dimension is a dimension perpendicular to an extension direction of the second electrodes.

When 100%<h1/h2≤200%, similarly, a transverse mode may be suppressed.

In a feasible implementation, the resonator further includes a first busbar and a second busbar. One of every two adjacent second electrodes among the plurality of second electrodes is a first interdigital electrode, and the other is a second interdigital electrode. The first interdigital electrode and the second interdigital electrode are spaced apart along the first direction. An extension direction of the first interdigital electrode and/or an extension direction of the second interdigital electrode are/is perpendicular to the first direction. A plurality of first interdigital electrodes among the plurality of second electrodes are connected through the first busbar. A plurality of second interdigital electrodes among the plurality of second electrodes are connected through the second busbar. An end portion, connected to the first busbar, of the first interdigital electrode is an electrode connection end, and the other end is an electrode tip. A second spacing is provided between the electrode tip and the second busbar. A second groove is provided at a position, facing the second spacing, on the piezoelectric layer, and the second groove communicates with the second spacing.

In a feasible implementation, the resonator further includes a plurality of gratings arranged in parallel. The plurality of gratings are connected through a first connection strip at one end, and the plurality of gratings are connected through a second connection strip at the other end. An extension direction of the gratings is the same as the extension direction of the second electrodes. One of every two adjacent second electrodes among the plurality of second electrodes is a first interdigital electrode, and the other is a second interdigital electrode. The first interdigital electrode and the second interdigital electrode are spaced apart along the first direction, and an extension direction of the first interdigital electrode and/or an extension direction of the second interdigital electrode are/is perpendicular to the first direction. A plurality of first interdigital electrodes among the plurality of second electrodes are connected through the first busbar, and a plurality of second interdigital electrodes among the plurality of second electrodes are connected through the second busbar. A spacing t between two adjacent gratings meets: $0.3 \leq t/P \leq 0.7$. P is a pitch, a width dimension of each first interdigital electrode is s1, a spacing between each first interdigital electrode and each second interdigital electrode that are adjacent to each other is s2, and the pitch P is equal to s1+s2. The width dimension is a dimension parallel to a surface of the substrate and perpendicular to the extension direction of the first interdigital electrode.

When $0.3 \leq t/p \leq 0.7$, a reflection grating may reflect back acoustic energy that is propagated outward, and concentrate energy of the resonator in an area, including the second electrodes, of the resonator, to increase the quality factor Q of the device.

In a feasible implementation, the piezoelectric layer includes a first side wall and a second side wall that are opposite to each other, and the first side wall and/or the second side wall are/is a plane perpendicular to the surface of the substrate and parallel to the extension direction of the second electrodes.

The first side wall and the second side wall may reflect back acoustic energy that is propagated outward, and concentrate energy of the resonator in an area, including the second electrodes, of the resonator, to increase the quality factor Q of the device.

In a feasible implementation, a material of the piezoelectric layer includes at least one of the following combinations: a combination of niobium and lithium, and a combination of tantalum and lithium; and a material of the first electrode includes at least one of tungsten, platinum, molybdenum, and aluminum.

For example, the material of the piezoelectric layer includes at least one of lithium niobate and lithium tantalate.

In a feasible implementation, a value of the electromechanical coupling factor component $k_{35}^2$ is the largest one of values of a plurality of electromechanical coupling factor components.

For example, the electromechanical coupling factor component $k_{35}^2$ may reach 0.9253.

In a feasible implementation, $0.4 < k_{35}^2$, or $0.4 < k_{35}^2 < 0.95$, or $0.4 < k_{35}^2 < 0.9253$.

In a feasible implementation, based on a voltage being applied to the plurality of second electrodes, the resonator is configured to generate a first-order anti-symmetry mode when exciting the electromechanical coupling factor component $k_{35}^2$ of the piezoelectric material. A vibration direction of the first-order anti-symmetry mode is parallel to the surface of the substrate and perpendicular to the extension direction of the second electrodes.

The first-order anti-symmetry mode A1 is a main resonance mode of the resonator.

In a feasible implementation, an electric field used by the resonator to excite at least a part of electromechanical coupling factor components other than the electromechanical coupling factor component $k_{35}^2$ is parallel to the extension direction of the second electrodes, and the at least a part of electromechanical coupling factor components include at least one of electromechanical coupling factor components $k_{21}^2$, $k_{22}^2$, $k_{23}^2$, $k_{24}^2$, $k_{25}^2$, and $k_{26}^2$.

**EP 4 637 031 A1**

To be specific, because the electric field for exciting the electromechanical coupling factor components $k_{21}^2$, $k_{22}^2$, $k_{23}^2$, $k_{24}^2$, $k_{25}^2$, and $k_{26}^2$ is along the extension direction of the second electrodes, electric field strength in this direction is basically zero, so that the electromechanical coupling factor components cause a small parasitic mode.

According to another aspect, this application further provides a resonator.

The resonator includes a first electrode, a piezoelectric layer, and a plurality of second electrodes. The plurality of second electrodes are arranged side by side. The piezoelectric layer has a first side and a second side, the plurality of second electrodes are located on the first side, and the first electrode and a substrate are located on the second side. That is, the first electrode and the second electrodes are located on two opposite sides of the piezoelectric layer. In this way, the piezoelectric layer is excited by a vertical electric field to generate resonance, for example, form a YBAR. In addition, in the resonator in this application, the piezoelectric layer includes a piezoelectric material, and a value of an electromechanical coupling factor component $k_{35}^2$ of the piezoelectric material meets: $k_{35}^2 > 0.4$.

In the resonator provided in this application, the value of the electromechanical coupling factor component $k_{35}^2$ of the piezoelectric material meets: $k_{35}^2 > 0.4$. For example, a Euler angle of the piezoelectric material is (90°, 90°, 120°±30°), or a Euler angle is (0°, 90°, 90°±30°). Under this limitation of a crystal orientation, the electromechanical coupling factor component $k_{35}^2$ of the resonator can reach a large value, so that the resonator has a large electromechanical coupling factor. For example, the electromechanical coupling factor may be greater than 40%.

In addition, for electromechanical coupling factor components, such as $k_{21}^2$, $k_{22}^2$, $k_{23}^2$, $k_{24}^2$, $k_{25}^2$, and $k_{26}^2$, with large values other than the electromechanical coupling factor component $k_{35}^2$, a direction of an electric field for exciting the electromechanical coupling factor components is parallel to an extension direction of the second electrodes. In addition, along the extension direction of the second electrodes, potentials on the second electrodes are the same, and electric field strength is zero. Therefore, the electromechanical coupling factor components $k_{21}^2$, $k_{22}^2$, $k_{23}^2$, $k_{24}^2$, $k_{25}^2$, and $k_{26}^2$ cause a small parasitic spurious mode. In this way, the parasitic spurious mode is further effectively suppressed on a basis that the resonator has a large electromechanical coupling factor.

In a feasible implementation, the piezoelectric material has a plurality of electromechanical coupling factor components, and the value of the electromechanical coupling factor component $k_{35}^2$ is the largest one of values of the plurality of electromechanical coupling factor components.

In a feasible implementation, $0.4 < k_{35}^2$, or $0.4 < k_{35}^2 < 0.95$, or $0.4 < k_{35}^2 < 0.9253$.

In a feasible implementation, based on a voltage being applied to the plurality of second electrodes, the resonator is configured to generate a first-order anti-symmetry mode when exciting the electromechanical coupling factor component $k_{35}^2$ of the piezoelectric material. A vibration direction of the first-order anti-symmetry mode is parallel to the surface of the substrate and perpendicular to the extension direction of the second electrodes.

The first-order anti-symmetry mode A1 is a main resonance mode of the resonator.

In a feasible implementation, an electric field used by the resonator to excite at least a part of electromechanical coupling factor components other than the electromechanical coupling factor component $k_{35}^2$ is parallel to the extension direction of the second electrodes, and the at least a part of electromechanical coupling factor components include at least one of electromechanical coupling factor components $k_{21}^2$, $k_{22}^2$, $k_{23}^2$, $k_{24}^2$, $k_{25}^2$, and $k_{26}^2$.

To be specific, because the electric field for exciting the electromechanical coupling factor components $k_{21}^2$, $k_{22}^2$, $k_{23}^2$, $k_{24}^2$, $k_{25}^2$, and $k_{26}^2$ is along the extension direction of the second electrodes, electric field strength in this direction is basically zero, so that the electromechanical coupling factor components cause a small parasitic mode.

According to still another aspect, this application further provides a preparation method for a resonator. The preparation method includes:

preparing a first electrode, a piezoelectric layer, and a plurality of second electrodes, where the piezoelectric layer has a first side and a second side, the plurality of second electrodes are located on the first side, the first electrode and a substrate are located on the second side, and the plurality of second electrodes are arranged side by side along a first direction.

A crystal cutting angle and a propagation direction of a piezoelectric material of the piezoelectric layer are X-cut and a (120°±30°) Y propagation direction, or a Euler angle of a crystal of a piezoelectric material is (90°, 90°, 120°±30°), where an X direction of the piezoelectric material and a thickness direction of the piezoelectric layer are a same direction, and the (120°±30°) Y direction of the piezoelectric material and the first direction are a same direction.

Alternatively, a crystal cutting angle and a propagation direction of a piezoelectric material are Y-cut and a (90°±30°) X propagation direction, or a Euler angle of a crystal of a piezoelectric material is (0°, 90°, 90°±30°), where a Y direction of the piezoelectric material and a thickness direction of the piezoelectric layer are a same direction, and the (90°±30°) X direction of the piezoelectric material and the first direction are a same direction.

In the resonator prepared by using the preparation method provided in this application, the crystal of the piezoelectric material is under this limitation of the Euler angle, so that the resonator can have a large electromechanical coupling factor. For example, the electromechanical coupling factor may be greater than 40%. In addition, when the crystal is at the Euler angle, for electromechanical coupling factor components, such as $k_{21}^2$, $k_{22}^2$, $k_{23}^2$, $k_{24}^2$, $k_{25}^2$, and $k_{26}^2$, with large values other than an electromechanical coupling factor component $k_{35}^2$, a direction of an electric field for exciting the electromechanical coupling factor components is parallel to an extension direction of the second electrodes. In addition, along the extension direction of the second electrodes, potentials on the second electrodes are the same, and electric field strength is basically zero. Therefore, the electromechanical coupling factor components $k_{21}^2$, $k_{22}^2$, $k_{23}^2$, $k_{24}^2$, $k_{25}^2$, and $k_{26}^2$ cause a small parasitic spurious mode. In this way, the parasitic spurious mode is further effectively suppressed on a basis that the resonator has a large electromechanical coupling factor.

In a feasible implementation, preparing the first electrode, the piezoelectric layer, and the plurality of second electrodes includes: forming a metal layer on one side of the piezoelectric layer; and bonding a structure including the piezoelectric layer and the metal layer to the substrate, so that the metal layer is stacked between the piezoelectric layer and the substrate, and the metal layer forms the first electrode.

In this way, a solid-state substrate resonator can be prepared.

In a feasible implementation, preparing the first electrode, the piezoelectric layer, and the plurality of second electrodes includes: bonding the piezoelectric layer to the substrate; providing a cavity in the substrate, where the cavity passes through the substrate from a rear surface of the substrate and extends to the piezoelectric layer, and the rear surface of the substrate is a surface away from the first electrode; and forming a metal layer on a bottom surface of the cavity, where the metal layer forms the first electrode.

In this way, a suspended cavity resonator can be prepared.

In a feasible implementation, preparing the plurality of second electrodes includes: disposing, on one side of the piezoelectric layer, a plurality of second electrodes that are arranged side by side, where a first spacing is provided between two adjacent second electrodes; and providing a first groove at a position, facing the first spacing, on the piezoelectric layer.

When the groove is provided on the piezoelectric layer, the groove helps further suppress or frequency-shift a parasitic spurious mode, and increase the electromechanical coupling factor of the resonator.

In a feasible implementation, before the first electrode is disposed on one side of the substrate, the preparation method further includes: disposing a dielectric layer on one side of the substrate, and then disposing the first electrode on one side, away from the substrate, of the dielectric layer, where a thickness g of the dielectric layer meets: $g=\lambda/4$, where $\lambda$ is a wavelength of the acoustic wave of the resonator at the resonance frequency in a material of the dielectric layer.

In this way, the electromechanical coupling factor can be further increased, to optimize performance of the prepared resonator.

In a feasible implementation, before the first electrode is disposed on one side, away from the substrate, of the dielectric layer, the preparation method further includes: disposing a first conductive connection layer on one side, away from the substrate, of the dielectric layer, and then disposing the first electrode on one side, away from the dielectric layer, of the first conductive connection layer; and before the piezoelectric layer is disposed on one side, away from the substrate, of the first electrode, the preparation method further includes: disposing a second conductive connection layer on one side, away from the substrate, of the first electrode, and then disposing the piezoelectric layer on one side, away from the first electrode, of the second conductive connection layer.

The conductive connection layer can be used to increase connection strength between film layers and reduce resistance.

In a feasible implementation, the preparation method further includes:

forming a cavity in the substrate; and
when the plurality of second electrodes are disposed on one side, away from the first electrode, of the piezoelectric layer, the preparation method further includes:
preparing a first busbar and a second busbar, where one of every two adjacent second electrodes among the plurality of second electrodes is a first interdigital electrode, and the other is a second interdigital electrode, where the first interdigital electrode and the second interdigital electrode are spaced apart along the first direction, an extension direction of the first interdigital electrode and/or an extension direction of the second interdigital electrode are/is perpendicular to the first direction, a plurality of first interdigital electrodes are connected through the first busbar, and a plurality of second interdigital electrodes are connected through the second busbar.

A pitch P and a thickness d of the piezoelectric layer meet: $P/d \geq 0.5$.

A width dimension of each first interdigital electrode is s1, a spacing between each first interdigital electrode and each second interdigital electrode that are adjacent to each other is s2, and the pitch P is equal to s1+s2. The width dimension is a dimension parallel to a surface of the substrate and perpendicular to the extension direction of the first interdigital electrode.

In a feasible implementation, when the plurality of second electrodes are disposed on one side, away from the first electrode, of the piezoelectric layer, the preparation method further includes:
preparing a first busbar and a second busbar, where one of every two adjacent second electrodes among the plurality of second electrodes is a first interdigital electrode, and the other is a second interdigital electrode, where the first interdigital electrode and the second interdigital electrode are spaced apart along the first direction, an extension direction of the first interdigital electrode and/or an extension direction of the second interdigital electrode are/is perpendicular to the first direction, a plurality of first interdigital electrodes are connected through the first busbar, and a plurality of second interdigital electrodes are connected through the second busbar.

A pitch P meets: P < , where Vs is a shear bulk acoustic wave velocity of the substrate, and f is an operating frequency of the resonator.

A width dimension of each first interdigital electrode is s1, a spacing between each first interdigital electrode and each second interdigital electrode that are adjacent to each other is s2, and the pitch P is equal to s1+s2. The width dimension is a dimension parallel to a surface of the substrate and perpendicular to the extension direction of the first interdigital electrode.

According to yet another aspect, this application further provides a filter. The filter may include a plurality of electrically connected resonators, and at least one of the plurality of resonators may be the foregoing resonator.

The filter provided in this application includes the resonator of the foregoing implementation structure. In addition, the resonator not only has a large electromechanical coupling factor but also can suppress or drift a parasitic spurious mode. The resonator is used in the filter, so that out-of-band suppression performance of the filter can be improved.

According to yet another aspect, this application further provides a duplexer. The duplexer includes a transmit-channel filter and a receive-channel filter. At least one of the transmit-channel filter and the receive-channel filter may perform filtering by using the foregoing filter.

According to yet another aspect, this application further provides a multiplexer. The multiplexer includes a plurality of transmit-channel filters and a plurality of receive-channel filters. At least one of the plurality of transmit-channel filters or at least one of the plurality of receive-channel filters may be the filter in embodiments of this application.

According to yet another aspect, this application further provides an electronic device. The electronic device includes an amplifier, and the filter, the duplexer, or the multiplexer in the foregoing feasible implementations. The filter, the duplexer, or the multiplexer may be electrically connected to the amplifier.

The electronic device provided in embodiments of this application includes the foregoing filter, duplexer, or multiplexer. Therefore, the electronic device provided in embodiments of this application and the filter, the duplexer, or the multiplexer in the foregoing technical solutions can resolve a same technical problem, with same expected effect achieved.

BRIEF DESCRIPTION OF DRAWINGS

FIG. 1 is a diagram of a partial structure of an electronic device;
FIG. 2 is a diagram of a partial structure of an electronic device;
FIG. 3 is a diagram of a partial structure of a filter in an electronic device;
FIG. 4 is a diagram of a partial structure of a resonator;
FIG. 5A is a diagram of a partial structure of a resonator;
FIG. 5B is a diagram of a partial structure of a resonator;
FIG. 6A shows a curve of admittance near a frequency of a main resonance mode SH1 in a structure shown in FIG. 5A;
FIG. 6B shows a curve of admittance near a frequency of a main resonance mode SH1 in a structure shown in FIG. 5B;
FIG. 7A is a diagram of a partial structure of a resonator according to an embodiment of this application;
FIG. 7B is a diagram of a partial structure of a resonator according to an embodiment of this application;
FIG. 8A shows a curve of admittance near a frequency of a main resonance mode A1 in a structure according to an embodiment of this application;
FIG. 8B shows a curve of admittance near a frequency of a main resonance mode SH1;
FIG. 9 is a diagram of a partial structure of a resonator according to an embodiment of this application;
FIG. 10 is a top view of a resonator according to an embodiment of this application;
FIG. 11A shows a curve of admittance near a frequency of a main resonance mode A1 in a structure according to an embodiment of this application;
FIG. 11B shows a curve of admittance near a frequency of a main resonance mode SH1;
FIG. 12 is a diagram of a partial structure of a resonator according to an embodiment of this application;
FIG. 13 is a diagram of a partial structure of a resonator according to an embodiment of this application;
FIG. 14 is a diagram of a partial structure of a resonator according to an embodiment of this application;
FIG. 15 is a diagram of a partial structure of a resonator according to an embodiment of this application;
FIG. 16 is a diagram of a partial structure of a resonator according to an embodiment of this application;
FIG. 17 is a top view of a resonator according to an embodiment of this application;
FIG. 18 is a cross-sectional view obtained through cutting along A-A in FIG. 17;
FIG. 19A is a diagram of a partial structure of a resonator according to an embodiment of this application;

FIG. 19B is a diagram of a partial structure of a resonator according to an embodiment of this application;

FIG. 20 is a line graph of an electromechanical coupling factor of a resonator according to an embodiment of this application;

FIG. 21 is a top view of a resonator according to an embodiment of this application;

FIG. 22 is a cross-sectional view obtained through cutting along B-B in FIG. 21;

FIG. 23 is a detailed diagram of a first interdigital electrode in FIG. 21;

FIG. 24 is a cross-sectional view obtained through cutting along C-C in FIG. 21;

FIG. 25A to FIG. 25C are diagrams of a process structure of a preparation method for a resonator according to an embodiment of this application;

FIG. 26A to FIG. 26E are diagrams of a process structure of a preparation method for a resonator according to an embodiment of this application;

FIG. 27 is a diagram of a structure of a filter according to an embodiment of this application;

FIG. 28 shows admittance curves of resonators in FIG. 27 and a filter passband;

FIG. 29 is a top view of a filter according to an embodiment of this application;

FIG. 30 shows a partial structure of a cross-sectional view of a filter according to an embodiment of this application; and

FIG. 31 shows a partial structure of a cross-sectional view of a filter according to an embodiment of this application.

Reference numerals:

100: electronic device;
200: filter;
300: resonator;
400, 410, 420, and 430: resonator;
500: antenna;
600: receiver;
700: transmitter;
800: baseband chip;
900: switch;
60a, 60c, and 70a: filter; 60b: low noise amplifier; 60d: frequency mixer; 60e: buffer; 60f and 70d: voltage-controlled oscillator; 70b: amplifier; 70c: driver;
10: substrate; 101: cavity;
20: first electrode;
30: piezoelectric layer;
40: second electrode; 401: first interdigital electrode; 402: second interdigital electrode;
50: dielectric layer;
601: first busbar; 602: second busbar;
60a and 60b: conductive connection layer;
701: first groove; 702: second groove;
80: protective layer;
90: Bragg reflection structure;
110 and 120: reflection grating; 10a: grating;
130 and 140: conductive connection layer;
150: dielectric layer.

DESCRIPTION OF EMBODIMENTS

Before a structure that can be implemented in embodiments of this application is described, technical terms in embodiments of this application are first described.

Piezoelectric effect, including direct piezoelectric effect and converse piezoelectric effect: The direct piezoelectric effect means that electric polarization of a piezoelectric material changes when the piezoelectric material is subject to a mechanical force. The converse piezoelectric effect means that a piezoelectric material is deformed after an external electric field is applied to the material. The piezoelectric effect is mainly caused by anisotropy and polarization of a crystal structure of the piezoelectric material.

Main resonance mode and parasitic spurious mode: A position of a parasitic resonance frequency generated by a resonator may be close to a position of a main resonance frequency, and parasitic resonance may affect the main resonance mode, and further affect in-band insertion loss performance and out-of-band suppression performance of a filter. The parasitic resonance of the resonator is usually referred to as a spurious mode or the parasitic spurious mode. When the spurious mode falls near the main resonance mode, for example, falls near a resonance point and an anti-resonance point of the main resonance mode, the in-band insertion loss performance and the out-of-band suppression performance of the filter are affected.

Electromechanical coupling factor (Piezoelectric coupling factor) $K_t^2$: a key parameter of a resonator. The electromechanical coupling factor $K_t^2$ may indicate efficiency of conversion between mechanical energy and electric energy. The electromechanical coupling factor $K_t^2$ of the resonator determines a relative frequency width of an anti-resonance frequency and a resonance frequency of the resonator. For example, when the resonator is used in a filter design, the relative frequency width directly determines bandwidth of the filter. It can be considered that a larger electromechanical coupling factor $K_t^2$ may indicate higher bandwidth and better performance of a filter constructed in a trapezoidal structure.

Electromechanical coupling factor component $k_{xy}^2$: For a single-crystal piezoelectric material, the electromechanical coupling factor component $k_{xy}^2$ has a fourth-order elasticity tensor c, a third-order piezoelectric tensor e, and a second-order dielectric tensor $\varepsilon$. Based on a right-handed rectangular coordinate system, the electromechanical coupling factor component $k_{xy}^2$ has an elasticity tensor component $c_{ijkl}$, a piezoelectric tensor component $e_{ijk}$, and a dielectric tensor component $\varepsilon_{ij}$, where i, j, k, l={1, 2, 3}. Due to symmetry of a single-crystal structure, for example, $c_{1323}=c_{3132}$, an order of a component may be simplified, and the following definitions may be made: {23, 32}→4, {13, 31}→5, and {12, 21}→6. For example, $c_{1323}=c_{3132} \to c_{54}$. In this case, an elasticity tensor component $c_{xy}$ (6×6), a piezoelectric tensor component $e_{ix}$ (3×6), and a dielectric tensor component $\varepsilon_{ij}$ (3×3) are obtained, where i, j={1, 2, 3}, and x, y={1, 2, 3, 4, 5, 6}. The electromechanical coupling factor component $k_{xy}^2$ is calculated based on the elasticity tensor component, the piezoelectric tensor component, and the dielectric tensor component of the material. A formula is as follows:

$$k_{xy}^2 = \frac{e_{xy}^2}{\varepsilon_{xx}^S c_{yy}^E},$$

where
x={1, 2, 3}, y={1, 2, 3, 4, 5, 6}, $\varepsilon_{xx}^S$ is a dielectric tensor component under fixed strain, and $c_{yy}^E$ is an elasticity tensor component under fixed electric field strength.

The following describes methods and formulas for calculating the elasticity tensor component, the piezoelectric tensor component, and the dielectric tensor component at different Euler angles of crystals.

For a crystal orientation of a piezoelectric material with a Euler angle of (0, 0, 0), for example, LN:

$c_{11}^E=2.03$, $c_{12}^E=0.53$, $c_{13}^E=0.75$, $c_{14}^E=0.09$, $c_{44}^E=0.60$, $c_{33}^E=2.43$, $c_{22}^E=c_{11}^E$, $c_{23}^E=c_{13}^E$, $c_{24}^E=-c_{14}^E$, $c_{55}^E=c_{44}^E$, $c_{56}^E=c_{14}^E$, and $c_{66}^E=(c_{11}^E-c_{12}^E)/2$, measured in a unit of $\times 10^{11}$ N/m²;
$e_{15}=3.70$, $e_{16}=-2.53$, $e_{31}=0.19$, $e_{33}=1.31$, $e_{21}=e_{16}$, $e_{22}=-e_{16}$, $e_{24}=e_{15}$, and $e_{32}=e_{31}$, measured in a unit of C/m²; and $\varepsilon_{11}^S=43.6\times\varepsilon_0$, $\varepsilon_{33}^S=29.2\times\varepsilon_0$, and $\varepsilon_{22}^S=\varepsilon_{11}^S$, where $\varepsilon_0$ is a vacuum dielectric constant: $8.85\times10^{-12}$ F/m. Other components may be obtained based on tensor symmetry, and a component without a value is zero. The components are expressed in simplified forms. The fourth-order elasticity tensor component $c_{ijkl}^E$ and the third-order piezoelectric tensor component $e_{ijk}$ may be correspondingly obtained through expansion.

In this case, for a crystal orientation of a piezoelectric material with a Euler angle of ($\alpha$, $\beta$, $\gamma$), an elasticity tensor component $c_{pqrs}^E{}'$, a piezoelectric tensor component $e_{pqr}'$, and a dielectric tensor component $\varepsilon_{pq}^S{}'$ that correspond to the crystal orientation may be calculated by using the following formulas:

$$c_{pqrs}^E{}'=c_{ijkl}^E A_{ip} A_{jq} A_{kr} A_{ls};$$

$$e_{pqr}'=e_{ijk} A_{ip} A_{jq} A_{kr};$$

and

$$\varepsilon_{pq}^S{}'=\varepsilon_{ij}^S A_{ip} A_{jq}.$$

The Einstein summation convention is used in the formulas, where a 3×3 matrix A=(cos$\alpha$cos$\gamma$-sin$\alpha$cos$\beta$sin$\gamma$,

-cos$\alpha$sin$\gamma$-sin$\alpha$cos$\beta$cos$\gamma$, sin$\alpha$sin$\beta$; sin$\alpha$cos$\gamma$+cos$\alpha$cos$\beta$sin$\gamma$, - sin$\alpha$sin$\gamma$+cos$\alpha$cos$\beta$cos$\gamma$, -cos$\alpha$sin$\beta$; sin$\beta$sin$\gamma$, sin$\beta$cos$\gamma$, cos$\beta$).

Relationship between an electromechanical coupling factor $K_t^2$ and an electromechanical coupling factor component $k_{xy}^2$: The electromechanical coupling factor $K_t$ is determined based on the electromechanical coupling factor component $k_{xy}^2$ and a mode excited by a specific resonator structure. Usually, a larger $k_{xy}^2$ corresponding to a main resonance mode of a resonator indicates a larger $K_t^2$ of the resonator. For example, when lithium niobate (lithium niobate, LN) is selected as a piezoelectric material, a maximum electromechanical coupling factor component $k_{xy}^2$ of the LN may reach 0.9253. A resonator that generates a main resonance mode by using the component has high overall electromechanical coupling performance. For example, an electromechanical coupling factor $K_t^2$ of the resonator may reach 25%. In addition, usually, a larger electromechanical coupling factor component $k_{xy}^2$ corresponding to the main resonance mode indicates a smaller remaining electromechanical coupling factor component $k_{xy}^2$, and a larger electromechanical coupling factor and a smaller parasitic spurious mode that are achieved by the resonator.

When a resonator structure is given, one resonance mode corresponds to one electromechanical coupling factor component $k_{xy}^2$. For example, the maximum electromechanical coupling factor component $k_{xy}^2$ of the LN may include $k_{16}^2$, $k_{15}^2$, $k_{34}^2$, and $k_{35}^2$. A mode generated by exciting the maximum electromechanical coupling factor component $k_{xy}^2$ is a main resonance mode, and a mode generated based on other electromechanical coupling factor components may be a spurious mode. For example, in an XBAR, a maximum electromechanical coupling factor component $k_{16}^2$ is excited to generate a zero-order shear horizontal mode (Zero-order Shear Horizontal mode): an SH0 mode, which is a main resonance mode; or in an XBAR, a maximum electromechanical coupling factor component $k_{15}^2$ is excited to generate a first-order anti-symmetry mode (First-order Anti-symmetry mode): an A1 mode, which is a main resonance mode; or in a YBAR, a maximum electromechanical coupling factor component $k_{34}^2$ is excited to generate a first-order shear horizontal mode (First-order Shear Horizontal mode): an SH1 mode, which is a main resonance mode.

Quality factor (Quality Factor) Q: represents energy utilization of a device, to be specific, a ratio of total energy received by the device to energy consumed within a vibration cycle. In a design of a filter, both an electromechanical coupling factor $K_t^2$ and a value of a quality factor Q of a resonator included in a filter are important parameters.

Euler angle (Euler angle) of a piezoelectric material: The Euler angle (Euler angle) represents a relative rotation angle relationship between an X direction or a Y direction of an original piezoelectric crystal structure and a direction, on a wafer plane, that is perpendicular or parallel to an electrode extension direction of a resonator.

Admittance (admittance): In power electronics, the admittance is defined as a reciprocal of impedance (impedance), is represented by a symbol Y, and is measured in a unit of siemens, S (S) for short. Like the impedance, the admittance is also a complex number, including a real number part (conductance G) and an imaginary number part (susceptance B): Y=G+jB.

Admittance curve abs and admittance curve Re: Admittance curve abs(Y)=|Y|, which is a modulus (also referred to as an amplitude) of Y and represents an overall response of a resonator. Re(Y) is a real part of Y, to be specific, conductance G, and represents a loss of the resonator.

R-a-R range: a frequency range around a resonance frequency (Resonance Frequency) fr and an anti-resonance frequency (Anti-resonance Frequency) fa. For example, the R-a-R range is (fr-(fa-fr)) to (fa+(fa-fr)).

Electromechanical coupling R-aR: represents an electromechanical coupling factor of a resonator based on relative bandwidth of a resonance frequency fr and an anti-resonance frequency fa. For example, the R-aR of the resonator should correspond to relative bandwidth of a target filter. R-aR=(fa-fr)/((fa+fr)/2).

Embodiments of this application provide an electronic device. The electronic device includes but is not limited to a radio frequency front-end, a filter and amplification module, and other products, and may further include a mobile phone (mobile phone), a tablet computer (pad), an intelligent wearable product (for example, a smartwatch or a smart band), a virtual reality (virtual reality, VR) device, augmented reality (augmented reality, AR), an uncrewed aerial vehicle, or other terminal devices, or may be a base station, a television, a router, a vehicle, or another device. A specific form of the electronic device is not specially limited in embodiments of this application.

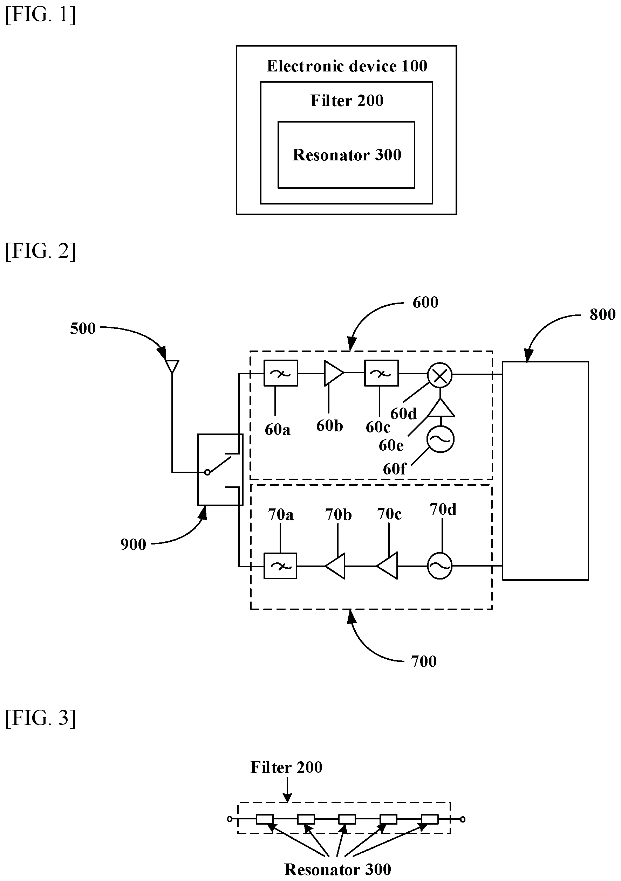

In the foregoing electronic device, as shown in FIG. 1, the electronic device 100 may include a filter 200. The filter 200 may effectively filter out a frequency of a specific frequency in a signal or a frequency other than the frequency, to obtain a signal with a specific frequency or a signal obtained by eliminating a specific frequency, to improve operation performance of the electronic device 100.

FIG. 2 is a diagram of a partial circuit of some electronic devices 100. As shown in FIG. 2, the electronic device 100 includes a receiver (Receiver) 600, a transmitter (Transmitter) 700, an antenna (Antenna) 500, and a baseband chip 800. The antenna 500 is electrically connected to the receiver 600 and the transmitter 700 through a switch 900, and the receiver 600 and the transmitter 700 are separately electrically connected to the baseband chip 800.

The receiver (Receiver) 600 shown in FIG. 2 includes a filter (Filter) 60a and a filter (Filter) 60c. A low noise amplifier 60b is electrically connected between the filter 60a and the filter 60c. The filter 60c is electrically connected to a buffer (Buffer) 60e through a frequency mixer (Mixer) 60d. The buffer 60e is electrically connected to a voltage-controlled oscillator 60f. FIG. 2 shows merely an example receiver, and an electronic component may be added or omitted based on this circuit structure.

The transmitter (Transmitter) 700 shown in FIG. 2 includes a power amplifier (power amplifier, PA) 70b. The power amplifier 70b is electrically connected to a filter 70a and a driver (Driver) 70c. The driver (Driver) 70c is electrically connected to a voltage-controlled oscillator 70d. Similarly, FIG. 2 shows merely an example transmitter, and an electronic component may be added or omitted based on this circuit structure.

For example, in the transmitter 700 shown in FIG. 2, the filter may effectively filter out a frequency of a specific frequency amplified by the power amplifier or a frequency other than the frequency, or the filter may filter out noise of the low noise amplifier.

Further, as shown in FIG. 3, the filter 200 may include a plurality of resonators 300 that are connected in series, or include a plurality of resonators 300 that are connected in parallel, or include resonators 300 that are connected in series and parallel.

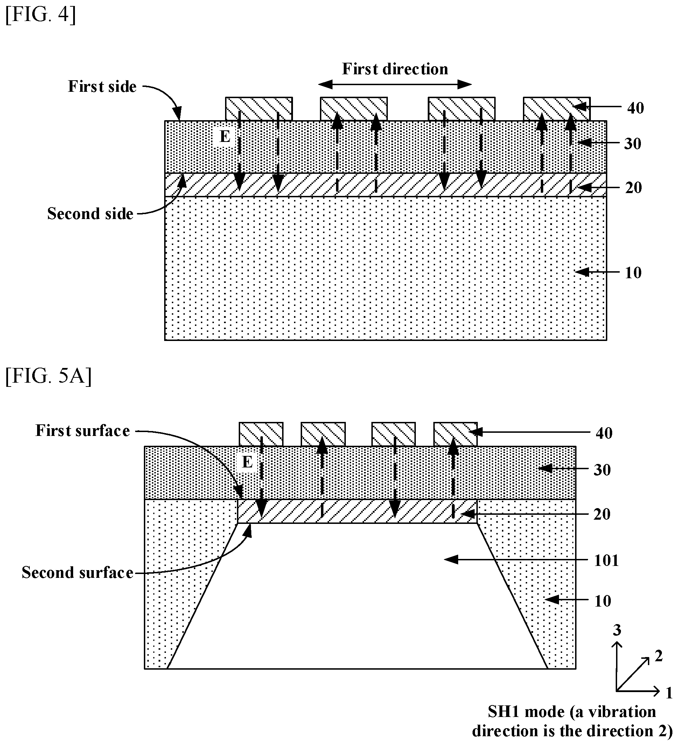

At least one of the plurality of resonators included in the filter 200 may be a resonator shown in FIG. 4.

FIG. 4 shows a part of a diagram of a process structure of a resonator. The resonator includes a substrate 10, a first electrode 20, a piezoelectric layer 30, and a plurality of second electrodes 40. The plurality of second electrodes 40 are arranged side by side along a first direction. The piezoelectric layer 30 has a first side and a second side. The plurality of second electrodes 40 are located on the first side. The first electrode 20 and the substrate 10 are located on the second side. For example, as shown in FIG. 4, the piezoelectric layer 30 is stacked between the first electrode 20 and the plurality of second electrodes 40.

In the example resonator shown in FIG. 4, for the plurality of second electrodes arranged along the first direction, the first direction may be understood as a direction perpendicular to or approximately perpendicular to an extension direction of the second electrodes 40. In an embodiment, the first direction is parallel to an extension direction of the piezoelectric layer 30. In other words, the first direction is perpendicular to a stacking direction of the piezoelectric layer, the first electrode, and the second electrodes.

The example structure in FIG. 4 may be used in a bulk acoustic resonator. A main operation principle of the bulk acoustic resonator is as follows: An input signal of a radio wave is converted into mechanical energy by using input and output transducers (Transducer) based on a piezoelectric effect characteristic of a piezoelectric material. Then the mechanical energy is converted into an electrical signal through processing, to filter out an unnecessary signal and noise, and improve signal reception quality.

During operation of the resonator shown in FIG. 4, the first electrode 20 may have no electrical signal connection, and an alternating voltage at a specific frequency is applied to the second electrodes 40, so that an electric field E is generated between the first electrode 20 and the second electrodes 40 along a thickness direction of the piezoelectric layer 30. The piezoelectric layer 30 produces piezoelectric effect by using the electric field. In the example in FIG. 4, the piezoelectric layer 30 is excited by the vertical electric field E to generate resonance, to cause conversion between electric energy and mechanical energy.

In the resonator shown in FIG. 4, resonance is excited along the thickness direction of the piezoelectric layer 30. In an embodiment, the resonator may be referred to as a vertically-excited bulk acoustic resonator (Vertically-excited Bulk Acoustic Resonator, YBAR). The thickness direction of the piezoelectric layer 30 herein may be understood as a direction, on the piezoelectric layer 30, that is parallel to a stacking direction of a plurality of film layers (the substrate, the first electrode, and the piezoelectric layer).

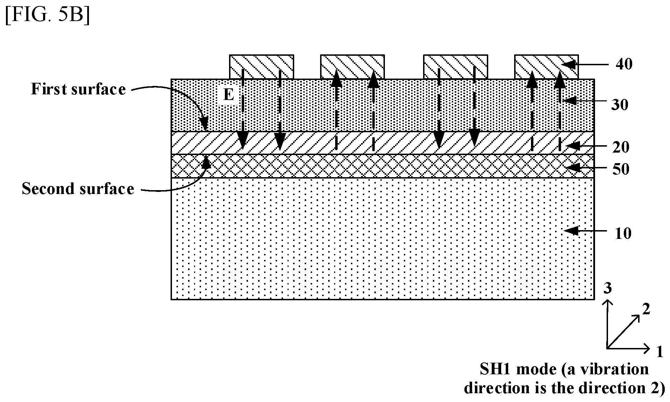

FIG. 5A and FIG. 5B are diagrams of process structures of resonators of two different structures. In FIG. 5A, a substrate 10 is provided with a cavity 101, and such a resonator may be referred to as a suspended cavity piezoelectric thin-film resonator. In FIG. 5B, compared with the substrate 10 in FIG. 5A, a substrate 10 in FIG. 5B is a solid structure without a cavity 101. In addition, compared with the structure in FIG. 5A, another layer structure may be stacked between a first electrode 20 and the substrate 10. For example, a dielectric layer 50 or a layer structure with another function is stacked between the substrate 10 and the first electrode 20. Such a resonator in FIG. 5B may be referred to as a solid-state substrate piezoelectric thin-film resonator.

Alternatively, the structures shown in FIG. 5A and FIG. 5B may be understood as follows: The first electrode 20 has a first surface and a second surface that are opposite to each other (which may also be referred to as facing away from each other or being reverse to each other), and the first surface is closer to a piezoelectric layer 30 than the second surface. In the suspended cavity piezoelectric thin-film resonator in FIG. 5A, the substrate 10 is provided with the cavity 101, at least a part of the second surface of the first electrode 20 is used to enclose the cavity 101, and at least a part of the first electrode 20 is disposed between the cavity 101 and the piezoelectric layer 30. In the solid-state substrate piezoelectric thin-film resonator in FIG. 5B, the first electrode 20 is disposed between the dielectric layer 50 and the piezoelectric layer 30, and the second surface of the first electrode 20 is completely provided on the dielectric layer 50. For example, in FIG. 5B, if the dielectric layer 50 is not disposed, the first electrode 20 is disposed between the substrate 10 and the piezoelectric layer 30, and the second surface of the first electrode 20 is completely provided on the substrate 10.

For the resonators of different structures in FIG. 4, FIG. 5A, and FIG. 5B, to use the resonator at higher passband bandwidth, for example, to satisfy passband bandwidth of a sub-2 GHz frequency band to a sub-15 GHz frequency band, the resonator needs to have a larger electromechanical coupling factor $K_t^2$.

Therefore, during design of the resonator, an electromechanical coupling factor component $k_{xy}^2$ that determines a value of the electromechanical coupling factor $K_t^2$ needs to be considered. For example, in the structures shown in FIG. 5A and FIG. 5B, if the piezoelectric layer 30 has a large electromechanical coupling factor component $k_{34}^2$, for example, the electromechanical coupling factor component $k_{34}^2$ reaches 0.9253, a corresponding first-order shear horizontal mode (First-order Shear Horizontal mode), that is, an SH1 mode, is excited as a main resonance mode. As shown in FIG. 5A and FIG. 5B, in the main resonance mode SH1, a vibration direction is a direction 2 shown in FIG. 5A and FIG. 5B. To be specific, the vibration direction is along an extension direction of the second electrodes 40.

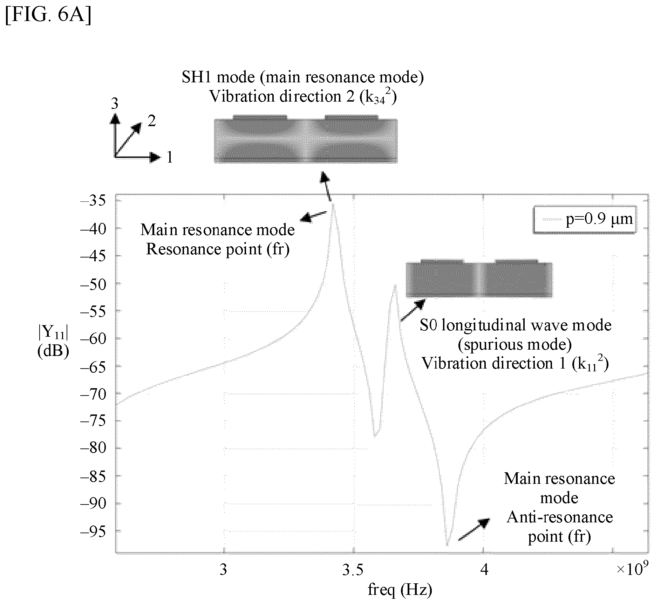

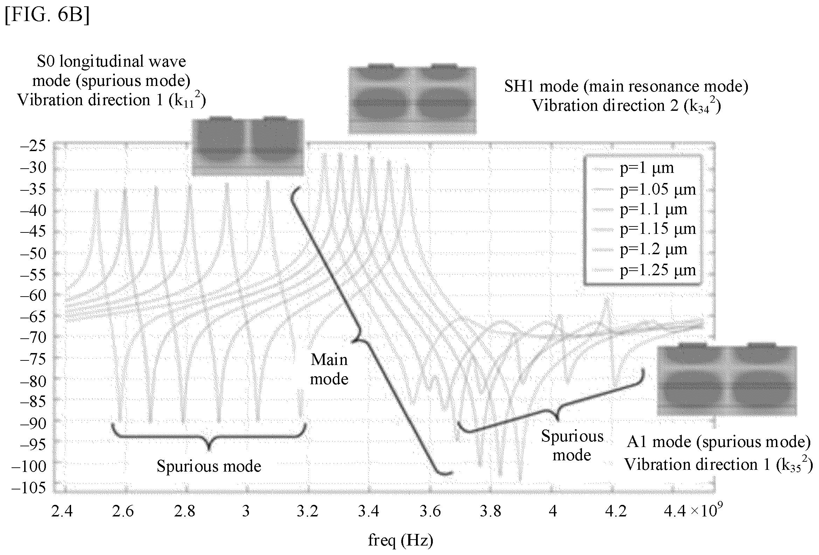

In the structures shown in FIG. 5A and FIG. 5B, although a large electromechanical coupling factor $K_t^2$ can be provided in the SH1 mode, several different types of parasitic modes appear near a frequency range of a resonance point of the main resonance mode of the resonator and a frequency range of an anti-resonance point of the main resonance mode. For example, FIG. 6A shows a curve of admittance near a frequency of the main resonance mode SH1 in the structure shown in FIG. 5A, and FIG. 6B shows a curve of admittance near a frequency of the main resonance mode SH1 in the structure shown in FIG. 5B.

As shown in FIG. 6A, when a pitch p is equal to 0.9 $\mu$m, a zero-order symmetry mode (Zero-order Symmetry mode), that is, an S0 longitudinal wave mode, is generated, as a parasitic spurious mode, between a resonance point of the main resonance mode and an anti-resonance point of the main resonance mode. The S0 longitudinal wave mode is generated by exciting an electromechanical coupling factor component $k_{11}^2$ by an electric field along a direction 1. In the S0 longitudinal wave mode, a vibration direction is along the direction 1. To be specific, the vibration direction is parallel to a surface of the substrate and is perpendicular to the extension direction of the second electrodes 40.

FIG. 6B shows a parasitic spurious mode generated when a pitch meets each of the following: p=1 $\mu$m, p=1.05 $\mu$m, p=1.1 $\mu$m, p=1.15 $\mu$m, p=1.2 $\mu$m, and p=1.25 $\mu$m. Regardless of whether the pitch is as small as 1 $\mu$m or as large as 1.25 $\mu$m, the parasitic spurious mode falls near the resonance point of the main resonance mode. For example, the parasitic spurious mode includes an S0 longitudinal wave mode and a first-order anti-symmetry mode (First-order Anti-symmetry mode), that is, an A1 mode. The S0 longitudinal wave mode is generated by exciting an electromechanical coupling factor component $k_{11}^2$ by an electric field along a direction 1. In the S0 longitudinal wave mode, a vibration direction is parallel to a surface of the substrate and is perpendicular to the extension direction of the second electrodes 40. The A1 mode is generated by exciting an electromechanical coupling factor component $k_{35}^2$ by an electric field along a direction 3. In the A1 mode, a vibration direction is parallel to the surface of the substrate and is perpendicular to the extension direction of the second electrodes 40.

In this embodiment of this application, the direction 1 may be understood as being parallel to the surface of the substrate and perpendicular to the extension direction of the second electrodes 40, the direction 2 is parallel to the extension direction of the second electrodes 40, and the direction 3 is parallel to the thickness direction of the piezoelectric layer 30.

In the following descriptions, $E_1$ is an electric field parallel to the surface of the substrate and perpendicular to the extension direction of the second electrodes 40, $E_2$ is an electric field parallel to the extension direction of the second electrodes 40, and $E_3$ is an electric field parallel to the thickness direction of the piezoelectric layer 30.

Based on FIG. 6A and FIG. 6B, although the resonator structure in which the main resonance mode SH1 is used has a large electromechanical coupling factor and may be used in a device with higher passband bandwidth, many other modes (for example, the A1 mode and the S0 longitudinal wave mode) are excited, and are displayed as parasitic spurious modes. The parasitic spurious modes affect passband insertion loss performance and out-of-band suppression performance of a device (for example, a filter).

The following embodiments of this application further provide some resonator structures. The resonator structures not only have a large electromechanical coupling factor, but also can suppress or frequency-shift a parasitic spurious mode, to optimize resonator performance.

In an example resonator of this application, a value of an electromechanical coupling factor component $k_{35}^2$ of a piezoelectric material of a piezoelectric layer 30 is a larger one or a largest one of values of a plurality of electromechanical coupling factor components, for example, $k_{35}^2 > 0.4$.

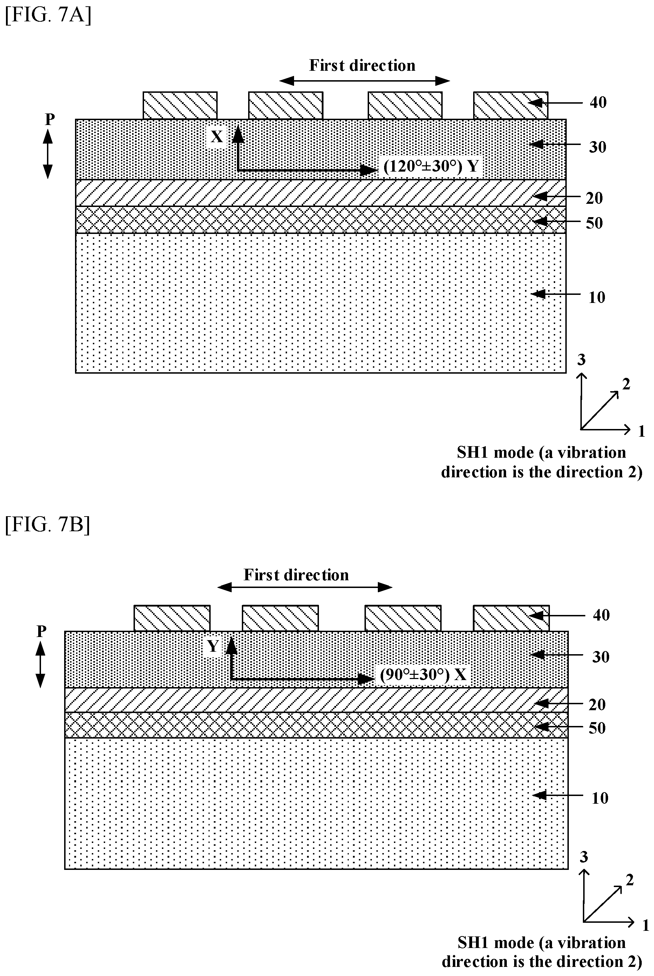

In the example resonator of this application, as shown in FIG. 7A, in some examples, a crystal cutting angle and a propagation direction of the piezoelectric material of the piezoelectric layer 30 in this embodiment of this application are X-cut and a (120°±30°) Y propagation direction. Alternatively, this may be understood as that a Euler angle of a crystal of the piezoelectric material is (90°, 90°, 120°±30°).

"X" in the foregoing X-cut represents an X direction of the piezoelectric material. The X-cut may indicate that the X direction of the piezoelectric material and a thickness direction (for example, a direction P in FIG. 7A) of the piezoelectric layer 30 are a same direction. The propagation direction of the piezoelectric material is parallel to a surface of the piezoelectric layer and perpendicular to an extension direction of second electrodes 40. In an embodiment, the (120°±30°) Y direction of the piezoelectric material and a first direction are a same direction.

For another example, as shown in FIG. 7B, in some other examples, a crystal cutting angle and a propagation direction of the piezoelectric material of the piezoelectric layer 30 in this embodiment of this application are Y-cut and a $(90°\pm30°)$ X propagation direction, or a Euler angle of a crystal of the piezoelectric material is $(0°, 90°, 90°\pm30°)$.

"Y" in the foregoing Y-cut represents a Y direction of the piezoelectric material. The Y-cut may indicate that the Y direction of the piezoelectric material and a thickness direction (for example, a direction P in FIG. 7B) of the piezoelectric layer 30 are a same direction. The $(90°\pm30°)$ X direction of the piezoelectric material and a first direction are a same direction.

The foregoing "same direction" is defined to allow a specific error, and may be an approximately same direction. In an embodiment, two angles with a difference within 5° (including 5°) may be considered as an approximately same direction.

In this embodiment of this application, the Euler angle, the cutting angle, or the propagation direction is limited. For example, precision of a cutting orientation of the piezoelectric material is usually less than $\pm0.5°$, for example, X-cut $\pm0.5°$ or Y-cut$\pm0.5°$. This may be expressed as $(90°\pm0.5°, 90°\pm0.5°, 120°\pm30°)$ or $(0°\pm0.5°, 90°\pm0.5°, 90°\pm30°)$ by using a Euler angle.

For example, the Euler angle may be $(89.5°, 90.5°, 150°)$, or the Euler angle may be $(89.5°, 90.5°, 90°)$, or the Euler angle may be $(89.5°, 90.5°, 120°)$, or the Euler angle may be $(89.5°, 90°, 110°)$, or the Euler angle may be $(90°, 90°, 140°)$.

For example, the Euler angle may be $(0.5°, 89.5°, 90°)$, or the Euler angle may be $(0°, 90.5°, 110°)$, or the Euler angle may be $(0°, 90.5°, 120°)$, or the Euler angle may be $(0.5°, 90.5°, 100°)$, or the Euler angle may be $(0.5°, 90°, 115°)$.

When the Euler angle of the piezoelectric material is $(90°, 90°, 120°\pm30°)$ or the Euler angle is $(0°, 90°, 90°\pm30°)$, the electromechanical coupling factor component $k_{35}^2$ can have a large value. For example, $k_{35}^2>0.4$, or $0.4<k_{35}^2<0.95$, or $0.4<k_{35}^2<0.9253$. In this way, a resonator in which a main resonance mode is excited by using $k_{35}^2$ also has a larger electromechanical coupling factor $K_t^2$. For example, the electromechanical coupling factor $K_t^2$ may be greater than 40%.

In addition, the electromechanical coupling factor component $k_{35}^2$ may generate a main resonance mode A1 under excitation of an electric field E3, and parasitic spurious modes generated under other electromechanical coupling factor components are also effectively suppressed or frequency-shifted out of an operating frequency range. For a status of suppression, refer to analysis in the following Table 1.

Table 1

| Large $k_{35}^2$ component | Large $k_{34}^2$ component | Maximum $k_{35}^2$ component | Maximum $k_{34}^2$ component | |
|---|---|---|---|---|
| A1 | SH1 | A1 | SH1 | Main resonance mode |
| $(0°, 90°, 90°)$ | $(0°, 90°, 0°)$ | $(90°, 90°, 120°)$ | $(90°, 90°, 30°)$ | Euler angle |
| 0 | 0.5907 | 0.004 | 0.9253 | $k_{34}^2$ |
| 0.5907 | 0 | 0.9253 | 0.004 | $k_{35}^2$ |
| 0 | 0 | 0 | 0 | $k_{36}^2$ |
| 0 | 0 | 0 | 0 | $K_{14}^2$ |
| 0 | 0.2218 | 0 | 0 | $K_{15}^2$ |
| 0 | 0.5907 | 0 | 0.03 | $K_{16}^2$ |
| 0.2218 | 0 | 0 | 0 | $K_{24}^2$ |
| 0 | 0 | 0 | 0 | $K_{25}^2$ |
| 0.5907 | 0 | 0.03 | 0 | $K_{26}^2$ |
| 0.027 | 0 | 0.07 | 0.32 | $K_{11}^2$ |
| 0 | 0.08 | 0 | 0 | $K_{31}^2$ |
| 0.08 | 0 | 0 | 0 | $K_{32}^2$ |
| 0.08 | 0.08 | 0 | 0 | $K_{33}^2$ |

(continued)

| Large $k_{35}^2$ component | Large $k_{34}^2$ component | Maximum $k_{35}^2$ component | Maximum $k_{34}^2$ component | |
|---|---|---|---|---|
| 0 | 0.027 | 0.32 | 0.07 | $K_{22}^2$ |

Content shown in Table 1 is as follows:

a maximum $k_{34}^2$ component in the related technology, a Euler angle, that is, (90°, 90°, 30°), of a crystal of a piezoelectric material, an excited main resonance mode, that is, an SH1 mode, and values of electromechanical coupling factor components; and a large $k_{34}^2$ component, a Euler angle, that is, (0°, 90°, 0°), of a crystal of a piezoelectric material, an excited main resonance mode, that is, an SH1 mode, and values of electromechanical coupling factor components; and

a maximum $k_{35}^2$ component provided in embodiments of this application, a Euler angle, that is, (90°, 90°, 120°), of a crystal of a piezoelectric material, an excited main resonance mode, that is, an A1 mode, and values of electromechanical coupling factor components; and a large $k_{35}^2$ component, a Euler angle, that is, (0°, 90°, 90°), of a crystal of a piezoelectric material, an excited main resonance mode, that is, an A1 mode, and values of electromechanical coupling factor components.

The following can be learned from the data, in Table 1, that is provided in the related technology and in embodiments of this application:

Based on a row of data under the maximum $k_{34}^2$ component in the related technology and a row of data under the maximum $k_{35}^2$ component in this application, the following can be learned:

When the maximum $k_{34}^2$ component in the related technology is used, the maximum $k_{34}^2$ component reaches 0.9253. However, an electromechanical coupling factor component $K_{16}^2$ excited by an electric field $E_1$ is equal to 0.03, an electromechanical coupling factor component $K_{11}^2$ excited by the electric field $E_1$ is equal to 0.32, and both electromechanical coupling factor components generate a parasitic spurious mode, because an electric field that excites related components is $E_1$. Because $E_1$ is perpendicular to an electrode extension direction and has a large value, a parasitic spurious mode is generated.

However, when the maximum $k_{35}^2$ component in this application is used, compared with the maximum $k_{34}^2$ component, the maximum $k_{35}^2$ component may also reach 0.9253, a large electromechanical coupling factor component $K_{11}^2$ that is equal to 0.32 is converted into $K_{22}^2$ that is equal to 0.32, and a large electromechanical coupling factor component $K_{16}^2$ that is equal to 0.03 is converted into $K_{26}^2$ that is equal to 0.03. An electric field that excites related components is $E_2$. Because the electric field $E_2$ is parallel to an extension direction of second electrodes 40, along the extension direction of the second electrodes 40, potentials are basically the same, and electric field strength is basically zero. Therefore, the electromechanical coupling factor components excite a small parasitic spurious mode.

When the large $k_{34}^2$ component in the related technology is used, compared with the maximum $k_{34}^2$ component, the large $k_{34}^2$ component may also reach 0.5907. However, an electromechanical coupling factor component $K_{15}^2$ excited by an electric field $E_1$ is equal to 0.2218, an electromechanical coupling factor component $K_{16}^2$ excited by the electric field $E_1$ is equal to 0.5907, and a parasitic spurious mode is generated.

However, when the large $k_{35}^2$ component in this application is used, compared with the large $k_{34}^2$ component, the large $k_{35}^2$ component may also reach 0.5907, a large electromechanical coupling factor component $K_{15}^2$ that is equal to 0.2218 is converted into $K_{24}^2$ that is equal to 0.2218, a large electromechanical coupling factor component $K_{16}^2$ that is equal to 0.5907 is converted into $K_{26}^2$ that is equal to 0.5907, and a large electromechanical coupling factor component $K_{31}^2$ that is equal to 0.08 is converted into $K_{32}^2$ that is equal to 0.08. Under the large electromechanical coupling factor components $K_{24}^2$, $K_{26}^2$, and $K_{32}^2$, an electric field for excitation is an electric field $E_2$. In the electric field $E_2$, along an extension direction of second electrodes 40, potentials are basically the same, and electric field strength is basically zero. Therefore, the electromechanical coupling factor components excite a small parasitic spurious mode.

In the foregoing data analysis for Table 1, whether a parasitic spurious mode is to be excited under an electromechanical coupling factor component may alternatively be determined by using the following formula.

In a resonance mode, stress caused by vibration is a second-order tensor, and values of components of the tensor are determined by the following piezoelectric constitutive equation. The equation is as follows:

$$T_{ij} = c_{ijmn}S_{mn} - e_{kij}E_k,$$

where

i, j, k, m, n={1, 2, 3}, T is stress, S is strain, E is electric field strength, c is an elasticity tensor, and e is a piezoelectric tensor.

The foregoing formula shows a correlation between stress $T_{ij}$ and $e_{kij}E_k$.

For example, in the data in Table 1, when the maximum component $k_{34}^2$ in the related technology is used, the electromechanical coupling factor component $K_{16}^2$ is equal to 0.03, and an electric field that excites the electromechanical coupling factor component $K_{16}^2$ is $E_1$. The electric field $E_1$ is large. Therefore, under excitation of the electric field, the electromechanical coupling factor component $K_{16}^2$ is excited to generate a parasitic mode. In this example, a value of a subscript k in the foregoing formula is equal to 1.

For another example, in the data in Table 1, when the maximum component $k_{35}^2$ in this application is used, the electromechanical coupling factor component $K_{22}^2$ is equal to 0.32, and an electric field that excites the electromechanical coupling factor component $K_{22}^2$ is $E_2$. The electric field $E_2$ is basically zero. Therefore, under excitation of the electric field, the electromechanical coupling factor component $K_{22}^2$ is basically not excited to generate a parasitic mode. To be specific, along the extension direction of the second electrodes 40, $E_2$ is quite small, and stress caused by piezoelectric effect and excited by $E_2$ is also small, so that vibration in a corresponding resonance mode is reduced. In this example, a value of a subscript k in the foregoing formula is equal to 2.

Therefore, through comparison between the $k_{34}^2$ component in the related technology and the $k_{35}^2$ component in this application, in embodiments of this application, a crystal orientation of a crystal of a piezoelectric material in the related technology is rotated by 90° along a direction 3 (to be specific, along a thickness direction of a piezoelectric layer) to obtain a crystal orientation structure in this application, to obtain the maximum $k_{35}^2$ component and obtain a main resonance mode A1 in a resonator structure.

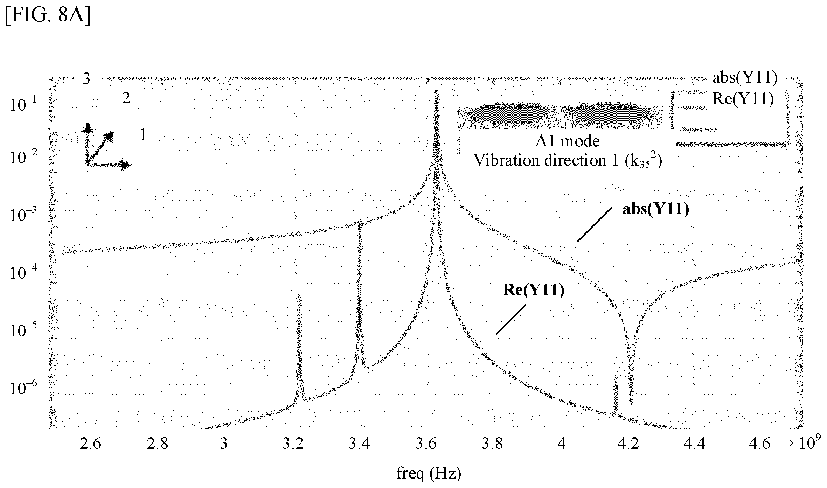

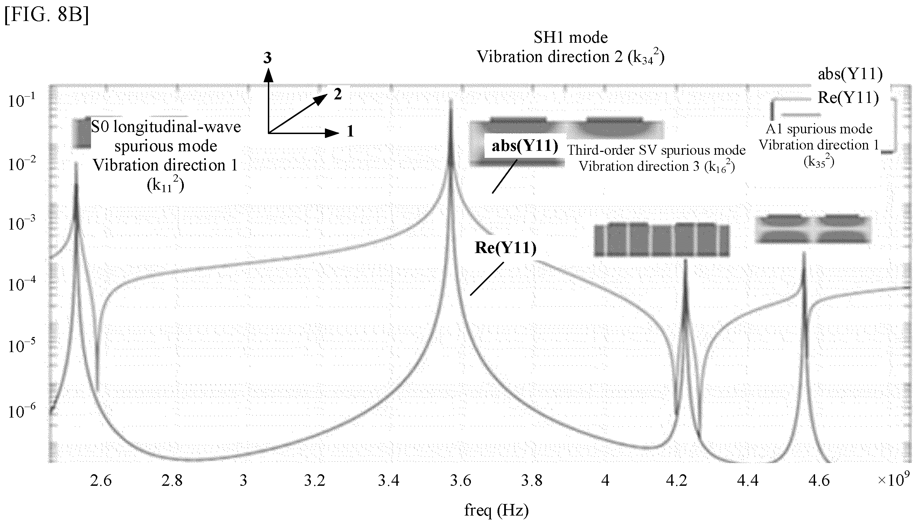

With reference to admittance curves shown in FIG. 8A and FIG. 8B, the following compares a parasitic spurious mode suppression status in an A1-mode resonator structure in this application with a parasitic spurious mode suppression status of an SH1-mode resonator structure in the related technology.

In addition, FIG. 8A and FIG. 8B are obtained by simulating the foregoing suspended cavity piezoelectric thin-film resonator.

For example, in FIG. 8A, an A1-mode resonator may obtain a maximum $K_{35}^2$ by using X-cut and a 120° Y propagation direction, with a Euler angle of a crystal of a piezoelectric material being (90°, 90°, 120°); and in FIG. 8B, an SH1-mode resonator may obtain a maximum $K_{34}^2$ by using X-cut and a 30° Y propagation direction, with a Euler angle of a crystal of a piezoelectric material being (90°, 90°, 30°).

FIG. 8A is a simulation curve obtained by using a structure limitation shown in Table 2, and FIG. 8B is a simulation curve obtained by using a structure limitation shown in Table 3.

Table 2

| | |
|---|---|
| Pitch | 1.4 μm |
| Thickness of a piezoelectric layer | 600 nm |
| Thickness of a first electrode | 50 nm |
| Width-to-spacing ratio | 0.58 |
| Electromechanical coupling factor $K_t^2$ | 30.1% |
| R-aR | 15.0% |

Table 3

| | |
|---|---|
| Pitch | 1.17 μm |
| Thickness of a piezoelectric layer | 500 nm |
| Thickness of a first electrode | 50 nm |
| Width-to-spacing ratio | 0.58 |
| Electromechanical coupling factor $K_t^2$ | 33.2% |
| R-aR | 17.0% |

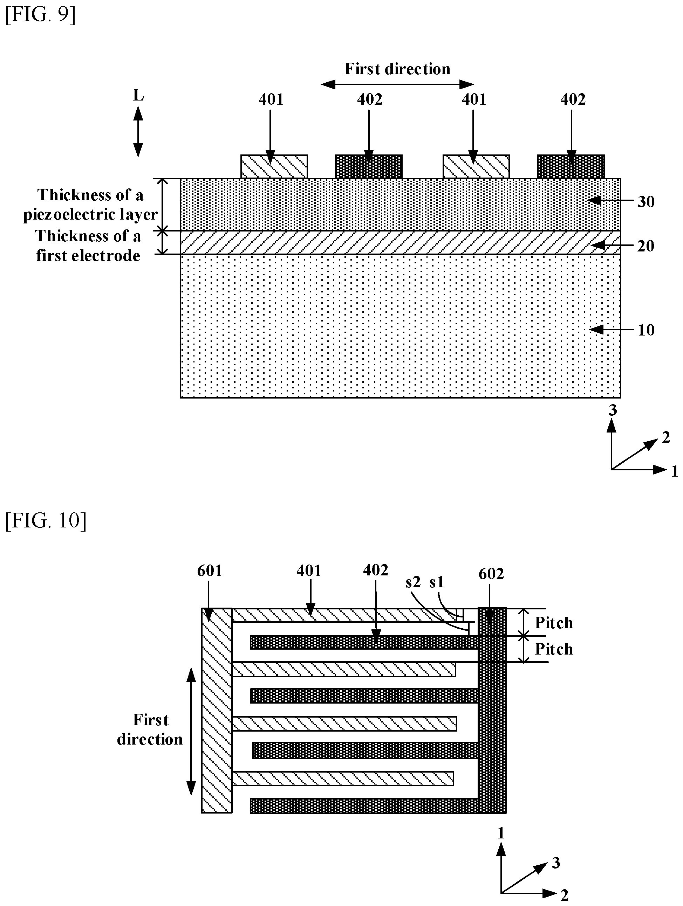

FIG. 9 is a diagram of a process structure of a resonator, and FIG. 10 is a diagram of distribution of second electrodes in FIG. 9. In FIG. 9, a plurality of second electrodes are disposed on a side, away from a first electrode 20, of a piezoelectric layer 30. The plurality of second electrodes include a plurality of first interdigital electrodes 401 and a plurality of second interdigital electrodes 402. For example, along a direction perpendicular to an extension direction of the first interdigital electrode 401, the plurality of first interdigital electrodes 401 and the plurality of second interdigital electrodes 402 may be disposed side by side, and the plurality of first interdigital electrodes 401 and the plurality of second interdigital electrodes 402 are arranged at spacings. To be specific, a second interdigital electrode 402 may be disposed between two adjacent first interdigital electrodes 401. Alternatively, the first interdigital electrode 401 and the second interdigital electrode 402 are spaced apart along a first direction, and an extension direction of the first interdigital electrode 401 and/or the second interdigital electrode 402 are/is perpendicular to the first direction.

The plurality of first interdigital electrodes 401 are connected through a first busbar 601, and the plurality of second interdigital electrodes 402 are connected through a second busbar 602. For example, the first busbar 601 and the second busbar 602 are arranged in parallel, and both the first busbar 601 and the second busbar 602 extend along a direction perpendicular to the extension direction of the first interdigital electrode 401 or the extension direction of the second interdigital electrode 402. As shown in FIG. 10, the first busbar 601 and the second busbar 602 extend along the first direction.

The pitch (Pitch) P in Table 2 and Table 3 may be understood as follows: As shown in FIG. 10, a width of each first interdigital electrode 401 is s1, a spacing between each first interdigital electrode 401 and each second interdigital electrode 402 that are adjacent to each other is s2, and the pitch (Pitch) P is a sum of the width s1 and the spacing s2.

In some examples, the width dimension s1 of the plurality of first interdigital electrodes 401 has a process tolerance, and the spacing s2 between each first interdigital electrode 401 and each second interdigital electrode 402 that are adjacent to each other also has a process tolerance.

The thickness of the piezoelectric layer and the thickness of the first electrode in Table 2 and Table 3 are a height dimension of the piezoelectric layer 30 and a height dimension of the first electrode 20 along a stacking direction (for example, a direction L in FIG. 9) of a plurality of film layer structures.

The width-to-spacing ratio in Table 2 and Table 3 is a ratio of the width s1 of the first interdigital electrode 401 to the pitch P, or a ratio of a width of the second interdigital electrode 402 to the pitch. In some examples, the width of the first interdigital electrode 401 is equal to the width of the second interdigital electrode 402.

Both the electromechanical coupling factors $K_t^2$ and R-aR in Table 2 and Table 3 may represent electromechanical coupling performance of the resonator. A larger electromechanical coupling factor $K_t^2$ and a larger R-aR indicate better electromechanical coupling performance. Still refer to FIG. 8A and FIG. 8B for further detailed descriptions.

The admittance curve in embodiments of this application that is shown in FIG. 8A includes a mode (abs) and a real part (Re) of the admittance curve. Basically, no large parasitic spurious mode appears between a resonance point of a main resonance mode A1 and an anti-resonance point of the main resonance mode A1, or near the resonance point of the main resonance mode A1, or near the anti-resonance point of the main resonance mode A1. In addition, FIG. 8A further shows that a vibration direction of the main resonance mode A1 is a direction 1 that is parallel to a substrate and that is perpendicular to an extension direction of second electrodes 40.

In the admittance curve of a related structure that is shown in FIG. 8B, a large S0 longitudinal-wave spurious mode, a large third-order SV spurious mode, a large A1 spurious mode, and the like are excited near a resonance point of a main resonance mode SH1 and near an anti-resonance point of the main resonance mode SH1.

As shown in FIG. 8B, a vibration direction of the main resonance mode SH1 is a direction 2 that is parallel to the extension direction of the second electrodes 40, a vibration direction of a parasitic spurious mode generated by exciting an electromechanical coupling factor component $K_{16}^2$ is a direction 3 that is parallel to a thickness direction of the piezoelectric layer 30, a vibration direction of a parasitic spurious mode generated by exciting an electromechanical coupling factor component $K_{11}^2$ is a direction 1 that is parallel to the substrate and that is perpendicular to the extension direction of the second electrodes 40, and a vibration direction of a parasitic spurious mode generated by exciting an electromechanical coupling factor component $K_{35}^2$ is the direction 1 that is parallel to the substrate and that is perpendicular to the extension direction of the second electrodes 40.

Based on FIG. 8A and FIG. 8B, through comparison between Table 2 and Table 3, it can be clearly learned that, although both the A1-mode resonator in this application and the SH1-mode resonator in the related technology have a large electromechanical coupling factor of approximately 30%, a parasitic spurious mode (for example, the S0 longitudinal mode, the third-order shear vertical mode, or the A1 mode) in the SH1-mode resonator is basically suppressed or frequency-shifted out of an R-a-R range in the A1-mode resonator.

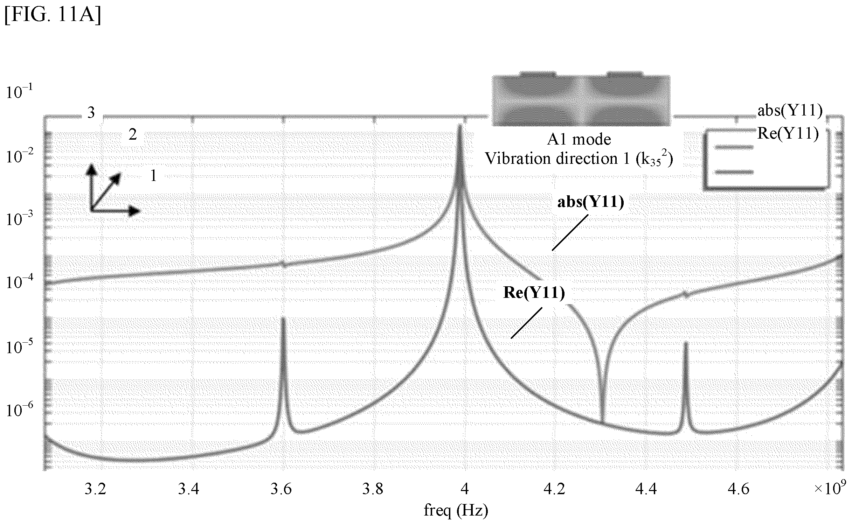

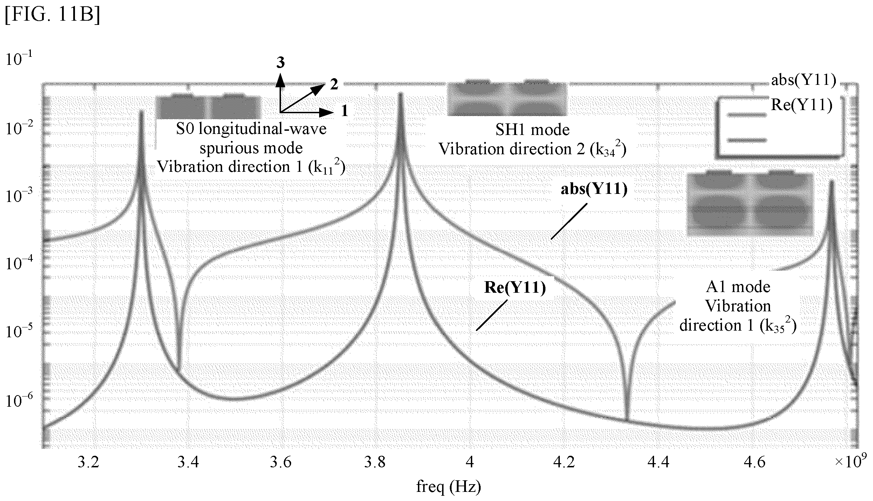

With reference to admittance curves shown in FIG. 11A and FIG. 11B, the following compares a parasitic spurious mode suppression status in an A1-mode resonator structure in this application with a parasitic spurious mode suppression status of an SH1-mode resonator structure in the related technology.

In addition, FIG. 11A and FIG. 11B are obtained by simulating the foregoing solid-state substrate piezoelectric thin-film resonator.

For example, in FIG. 11A, an A1-mode resonator may obtain a maximum $K_{35}^2$ by using X-cut and a 120° Y propagation direction, with a Euler angle of a crystal of a piezoelectric material being (90°, 90°, 120°); and in FIG. 11B, an SH1-mode resonator may obtain a maximum $K_{34}^2$ by using X-cut and a 30° Y propagation direction, with a Euler angle of a crystal of a piezoelectric material being (90°, 90°, 30°).

FIG. 11A is a simulation curve obtained by using a structure limitation shown in Table 4, and FIG. 11B is a simulation curve obtained by using a structure limitation shown in Table 5.

Table 4

| Pitch | 1.1 $\mu$m |
|---|---|
| Thickness of a piezoelectric layer | 600 nm |
| Thickness of a first electrode | 50 nm |
| Thickness of a dielectric layer | 250 nm |
| Width-to-spacing ratio | 0.4 |
| Electromechanical coupling factor $K_t^2$ | 16.8% |
| R-aR | 7.6% |

Table 5

| Pitch | 0.92 $\mu$m |
|---|---|
| Thickness of a piezoelectric layer | 500 nm |
| Thickness of a first electrode | 50 nm |
| Thickness of a dielectric layer | 250 nm |
| Width-to-spacing ratio | 0.4 |
| Electromechanical coupling factor $K_t^2$ | 24.6% |
| R-aR | 11.8% |

For explanations of each film layer structure in Table 4 and Table 5, refer to Table 2 and Table 3. Details are not described herein again.

In the admittance curve in embodiments of this application that is shown in FIG. 11A, basically, no large parasitic spurious mode appears between a resonance point of a main resonance mode A1 and an anti-resonance point of the main resonance mode A1, or near the resonance point of the main resonance mode A1, or near the anti-resonance point of the main resonance mode A1. In addition, FIG. 11A further shows that a vibration direction of the main resonance mode A1 is a direction 1 that is perpendicular to an extension direction of second electrodes 40.

In the admittance curve of a related structure that is shown in FIG. 11B, a large S0 longitudinal-wave spurious mode, a large A1 spurious mode, and the like are excited near a resonance point of a main resonance mode SH1 and near an anti-resonance point of the main resonance mode SH1.

As shown in FIG. 11B, a vibration direction of the main resonance mode SH1 is a direction 2 that is parallel to the extension direction of the second electrodes 40, a vibration direction of a parasitic spurious mode generated by exciting an electromechanical coupling factor component $K_{11}^2$ is a direction 1 that is parallel to a substrate and that is perpendicular to the extension direction of the second electrodes 40, and a vibration direction of a parasitic spurious mode generated by exciting an electromechanical coupling factor component $K_{35}^2$ is the direction 1 that is parallel to the substrate and that is perpendicular to the extension direction of the second electrodes 40.

In embodiments of this application, a main vibration position of the main resonance mode A1 generated by exciting the electromechanical coupling factor component $K_{35}^2$ is inside a piezoelectric layer and below the second electrodes 10. The vibration direction is in a first-order anti-symmetry form relative to a thickness direction of the piezoelectric layer. To be specific, an upper part and a lower part are divided along the thickness direction of the piezoelectric layer, and vibration directions of the upper part and the lower part are opposite in an anti-symmetry form.

Based on FIG. 11A and FIG. 11B, through comparison between Table 4 and Table 5, it can be clearly learned that, although both the A1-mode resonator in this application and the SH1-mode resonator in the related technology have a large electromechanical coupling factor, a parasitic spurious mode (for example, the S0 longitudinal mode or the A1 mode) in the SH1-mode resonator is basically suppressed or frequency-shifted out of an R-a-R range in the A1-mode resonator.

In embodiments of this application, a large electromechanical coupling factor $K_{35}^2$ is obtained by changing a crystal orientation, and is excited in a resonator structure to generate the main resonance mode A1, with a parasitic spurious mode effectively suppressed. This solution may be applied not only to the suspended cavity piezoelectric thin-film resonator, but also to the solid-state substrate piezoelectric thin-film resonator structure and the following resonator structure.

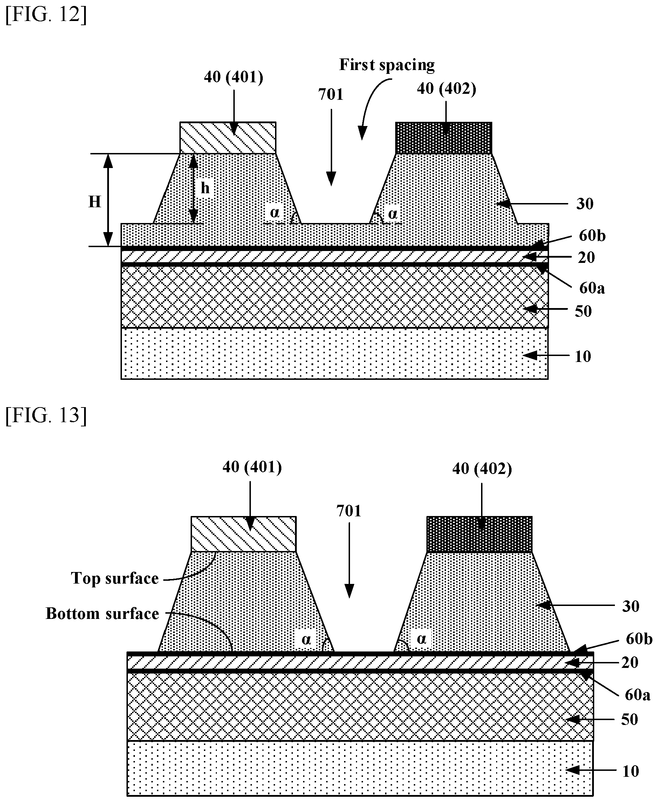

FIG. 12 shows a part of a process structure of a resonator according to an embodiment of this application. The resonator includes a substrate 10, a dielectric layer 50 formed on the substrate 10, a first electrode 20 formed on a side, away from the substrate 10, of the dielectric layer 50, a piezoelectric layer 30 formed on a side, away from the dielectric layer 50, of the first electrode 20, and a plurality of second electrodes 40 formed on a side, away from the first electrode 20, of the piezoelectric layer 30.

In the resonator provided in the foregoing embodiment, the substrate 10 may be a high-acoustic-velocity substrate, for example, may be any one of silicon carbide (SiC), diamond (diamond), and boron nitride (BN), or a combination thereof.

A material of the piezoelectric layer 30 includes at least one of the following combinations: a combination of niobium and lithium, and a combination of tantalum and lithium. For example, the material of the piezoelectric layer 30 includes any one of lithium tantalate ($LiTaO_3$), lithium niobate ($LiNbO_3$), aluminum nitride (AlN), and zinc oxide (ZnO), or a combination thereof.

The first electrode 20 may be any possible conductive metal (including but not limited to Al, Cu, W, Mo, Ru, Pt, and the like), or may be conductive metal (including but not limited to W, Ru, Mo, Pt, and the like) with high acoustic impedance. The metal with high acoustic impedance helps increase an electromechanical coupling factor and a quality factor Q, and further improve performance of the resonator.

The second electrode 40 may be any possible conductive metal (including but not limited to Al, Cu, W, Mo, Ru, Pt, and the like). The first electrode 20 and the second electrode 40 may be same conductive metal or different conductive metal.

To increase connection strength between the first electrode 20 and the dielectric layer 50, a conductive connection layer 60a may be stacked between the dielectric layer 50 and the first electrode 20, as shown in FIG. 12.

Alternatively, in some other examples, to increase connection strength between the piezoelectric layer 30 and the first electrode 20, a conductive connection layer 60b may be stacked between the piezoelectric layer 30 and the first electrode 20, still as shown in FIG. 12.

The conductive connection layer 60a and the conductive connection layer 60b in FIG. 12 may be made of a same material or different materials. For example, any possible conductive metal (including but not limited to Ti and Cr) may be selected.

In some examples, bonding strength of the conductive connection layer may range from 10 MPa to 40 GPa, for example, may be 1.5 GPa.

In the example shown in FIG. 12, the piezoelectric layer 30 may be made of lithium niobate ($LiNbO_3$), a crystal cutting angle and a propagation direction may be X-cut and a ($120°\pm30°$) Y propagation direction, and a Euler angle of a crystal of a piezoelectric material is ($90°$, $90°$, $120°\pm30°$); or a crystal cutting angle and a propagation direction are Y-cut and a ($90°\pm30°$) X propagation direction, and a Euler angle of a crystal of a piezoelectric material is ($0°$, $90°$, $90°\pm30°$). In this way, an electromechanical coupling factor $k_{35}^2$ of the resonator can be greater than 0.4, or even equal to 0.9253. Further, an electromechanical coupling factor of an entire device may reach approximately 40%, and the device may be used in a scenario with higher passband bandwidth, for example, may be used in a sub-6 GHz frequency band with high passband bandwidth.

Still refer to FIG. 12. In the resonator structure provided in this embodiment of this application, a first groove 701 is further provided, a first spacing is provided between two adjacent second electrodes 40, the first groove 701 is provided in the piezoelectric layer 30, and the first groove 701 faces the first spacing. This may be understood as that the first groove 701 communicates with the first spacing.

The first groove 701 may help increase an electromechanical coupling factor $K_t^2$ of the resonator, and the first groove 701 further helps suppress or frequency-shift a parasitic mode.

In some examples, as shown in FIG. 12, the first groove 701 does not pass through the piezoelectric layer 30. In an example resonator structure in FIG. 13, the first groove 701 passes through the piezoelectric layer 30 and extends to the conductive connection layer 60b.

It can be understood that, in the structure shown in FIG. 13, the piezoelectric layer 30 has a bottom surface and a top surface that are opposite to each other (or referred to as facing away from each other), and the bottom surface is closer to the substrate 10 than the top surface. In FIG. 13, the first groove 701 extends from the top surface to the bottom surface, to pass through the piezoelectric layer 30.

In some implementation structures, a deeper first groove 701 indicates a larger electromechanical coupling factor $K_t^2$ of the resonator. In this embodiment of this application, as shown in FIG. 12, a depth h of the first groove 701 may meet: 30% $H \leq h \leq H$, where H is a thickness dimension of the piezoelectric layer 30.

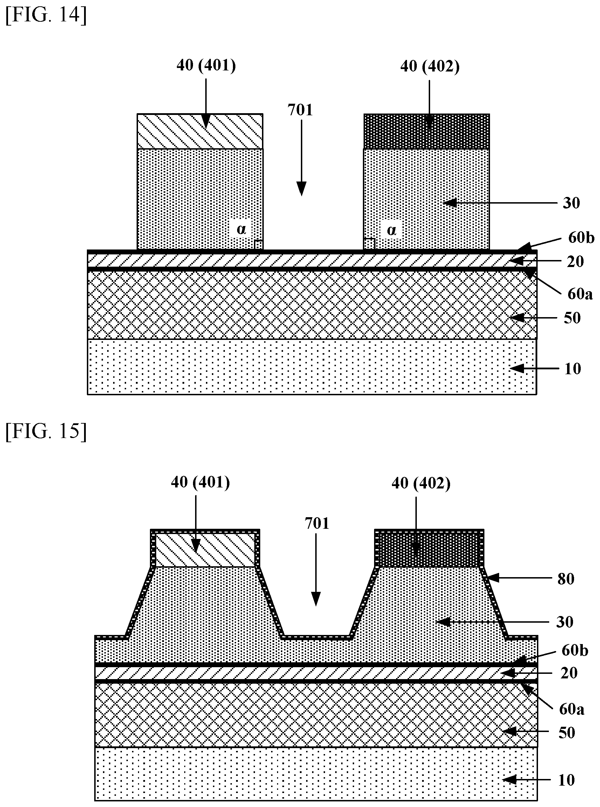

In addition, in some feasible examples, as shown in FIG. 12 and FIG. 13, a radial size of the first groove 701 gradually decreases along a direction from the top surface to the bottom surface of the first groove 701. For example, a tilt angle $\alpha$ of the first groove 701 may be as follows: $45° \leq \alpha \leq 90°$. For example, in FIG. 12 and FIG. 13, the tilt angle $\alpha$ is approximately $60°$, and in FIG. 14, the tilt angle $\alpha$ is approximately $90°$.

The tilt angle $\alpha$ of the first groove 701 may be understood as an included angle between a side surface of the first groove 701 and a reference plane, and the reference plane is a plane parallel to a surface of the substrate 10.

FIG. 15 is a diagram of a process structure of another resonator according to an embodiment of this application. Compared with FIG. 12 to FIG. 14, in this embodiment, a protective layer 80 is further included, and a side surface, away from a piezoelectric layer 30, of a second electrode 40, a side surface of the second electrode 40, and a side surface and a bottom surface of a first groove 701 may all be covered by the protective layer 80. The protective layer 80 may be used to protect the resonator from potential corrosion, scratches, oxidation, or the like.

The protective layer 80 may be made of a dielectric material, for example, may be made of silicon oxide or silicon nitride.

In addition, the protective layer 80 may further adjust an electromechanical coupling factor, a temperature coefficient (Temperature coefficient of frequency, TCF), and the like of the resonator, to further optimize operation performance of the resonator.

To further increase the electromechanical coupling factor of the resonator, as shown in FIG. 15, in this embodiment of this application, a thickness g of a dielectric layer 50 stacked on one side of a substrate 10 may meet: $g=\lambda/4$, where $\lambda$ is a wavelength of an acoustic wave of the resonator at a resonance frequency in a material of the dielectric layer 50.

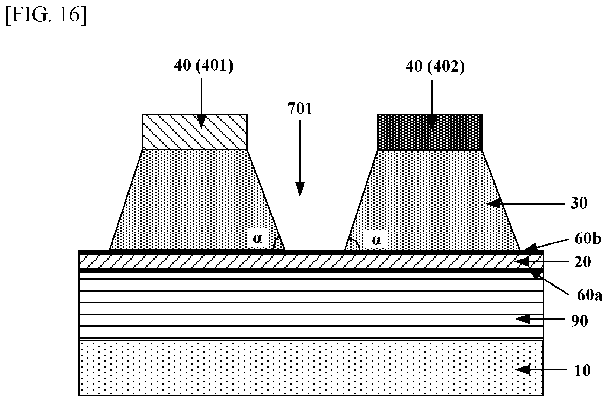

FIG. 16 is a diagram of a process structure of still another resonator according to an embodiment of this application. In FIG. 16, a Bragg reflection structure 90 is formed on a substrate 10, a first electrode 20 is disposed on a side, away from the substrate 10, of the Bragg reflection structure 90, a piezoelectric layer 30 is stacked between the first electrode 20 and second electrodes 40, and conductive connection layers (60a and 60b) are stacked between the piezoelectric layer 30 and the first electrode 20 and between the first electrode 20 and the Bragg reflection structure 90.

The Bragg reflection structure 90 includes a plurality of layers of stacked film layer structures, and is formed by alternately stacking a high-acoustic-impedance material and a low-acoustic-impedance material. The high-acoustic-impedance material includes but is not limited to tungsten (W), hafnium oxide ($HfO_2$), molybdenum (Mo), and the like. The low-acoustic-impedance material includes but is not limited to silicon oxide ($SiO_2$) and the like. The alternately stacked structures form Bragg reflection effect for an acoustic wave that may be propagated downward, to suppress downward energy leakage, and increase a Q value and an electromechanical coupling factor of the resonator.

For example, the Bragg reflection structure includes a first reflection layer and a second reflection layer that are stacked. A thickness t1 of the first reflection layer meets: $\frac{1}{8}\lambda_1 \leq t1 \leq \frac{3}{8}\lambda_1$ ; and a thickness t2 of the second reflection layer meets: $\frac{1}{8}\lambda_2 \leq t2 \leq \frac{3}{8}\lambda_2$ , where $\lambda_1$ is a wavelength of an acoustic wave of the resonator at a resonance frequency in a material of the first reflection layer, and $\lambda_2$ is a wavelength of the acoustic wave in a material of the second reflection layer.

In some examples, $t1=\frac{1}{4}\lambda_1$ , and $t2=\frac{1}{4}\lambda_2$ . In some other examples, $t1=\frac{1}{8}\lambda_1$ , and $t2=\frac{1}{8}\lambda_2$ . In still some examples, $t1=\frac{3}{8}\lambda_1$ , and $t2=\frac{3}{8}\lambda_2$ .

If the first reflection layer and the second reflection layer are considered as one group, in some examples, the Bragg reflection structure may include three groups, or more groups, for example, 10 groups.

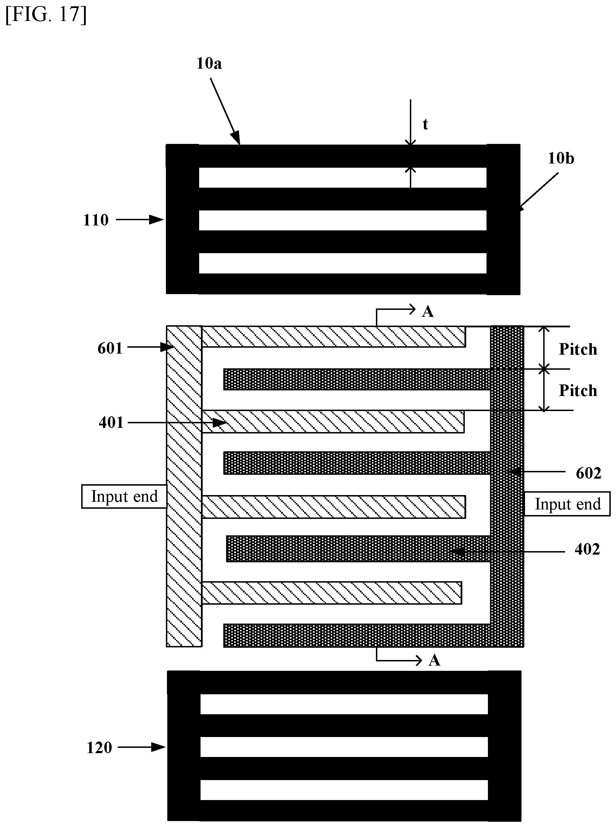

In the foregoing different embodiments, the second electrodes 40 formed on one side of the piezoelectric layer 30 may be arranged in a manner shown in FIG. 17, and the second electrodes 40 include a plurality of first interdigital electrodes 401 and a plurality of second interdigital electrodes 402. The plurality of first interdigital electrodes 401 and the plurality of second interdigital electrodes 402 may be disposed side by side, and the plurality of first interdigital electrodes 401 and the plurality of second interdigital electrodes 402 are arranged at spacings. To be specific, a second interdigital electrode 402 may be disposed between two adjacent first interdigital electrodes 401.

The plurality of first interdigital electrodes 401 are connected through a first busbar 601, and the plurality of second interdigital electrodes 402 are connected through a second busbar 602.

When the foregoing substrate is a solid-state high-acoustic-velocity substrate, for example, the solid-state high-acoustic-velocity substrate may be at least one of diamond (diamond), silicon carbide (SiC), and boron nitride (BN), a pitch P may meet: p<Vs/2f, where Vs is a shear bulk acoustic wave velocity of the substrate 10, and f is an operating frequency of the resonator. This can prevent energy leakage in a direction toward the substrate 10, and increase the Q value and the electromechanical coupling factor of the resonator.

In some examples, as shown in FIG. 17, the first busbar 601 and the second busbar 602 are arranged in parallel, and may extend along a direction perpendicular to an extension direction of the second electrodes.

The first busbar 601 may serve as an input end, and the second busbar 602 may serve as an output end. For example, an alternating voltage within a specific frequency range may be input to the plurality of first interdigital electrodes 401 through the first busbar 601, and an alternating voltage signal obtained through processing by the resonator may be output to the plurality of second interdigital electrodes 402 through the second busbar 602.

In addition, a reflection grating is further disposed on a side of the plurality of first interdigital electrodes 401 and the plurality of second interdigital electrodes 402. For example, FIG. 17 shows a reflection grating 110 and a reflection grating 120. The reflection grating 110 and the reflection grating 120 may reflect back acoustic energy that is propagated outward, and mainly concentrate resonance energy of an acoustic wave in an area in which the second electrodes of the resonator are located.

Still refer to FIG. 17. The reflection grating includes a plurality of gratings 10a arranged in parallel, and an extension direction of the gratings 10a is consistent with the extension direction of the second electrodes 40. Herein, that the extension directions are consistent (or the extension directions are the same) may be understood as that there is a specific process error. For example, an angle between the extension directions may be within 2°.

The reflection grating further includes a connection strip 10b. The plurality of gratings 10a are connected through one connection strip 10b at one end, and the plurality of gratings 10a are connected through another connection strip 10b at the other end.

As shown in FIG. 17, a spacing t between two adjacent gratings 10a meets: $0.3 \leq t/p \leq 0.7$, where p is a pitch. For example, $t/p=0.5$. When the spacing t between two gratings 10a meets the foregoing condition, acoustic energy that is propagated outward can be better reflected back, to increase a quality factor Q of the resonator.

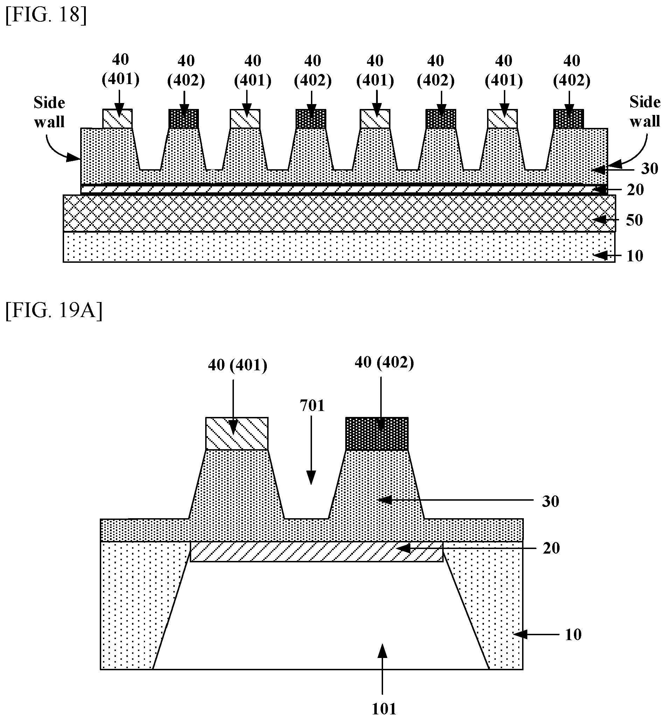

In addition, FIG. 18 is a cross-sectional view obtained by cutting FIG. 17 along an A-A direction. At an end of the resonator, a side wall of the piezoelectric layer 30 may be of a vertical structure, and acoustic energy that is propagated outward may be reflected by the vertical side wall of the piezoelectric layer, to increase the quality factor Q of the resonator.

The side wall of the piezoelectric layer 30 in FIG. 18 may be understood as a side wall close to ends of the plurality of second electrodes 40. The side wall is perpendicular to a surface of the substrate and is parallel to the extension direction of the second electrodes.

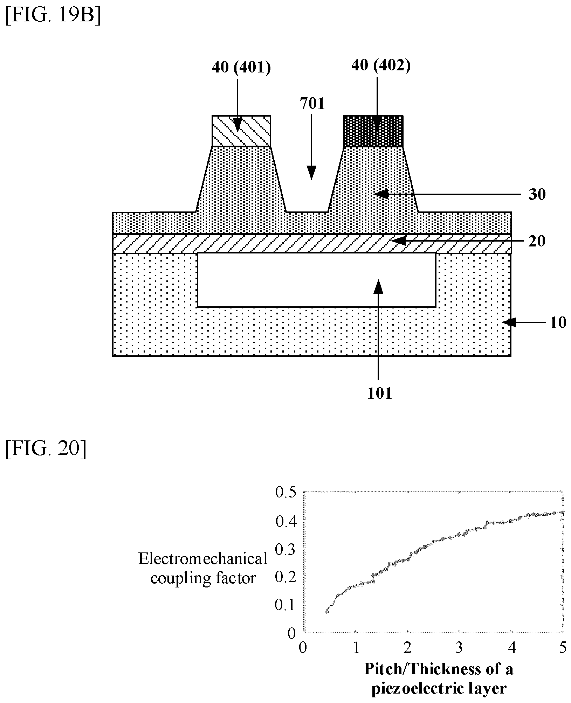

FIG. 12 to FIG. 18 show a solid-state substrate piezoelectric thin-film resonator, and FIG. 19A and FIG. 19B each show a suspended cavity piezoelectric thin-film resonator. In FIG. 19A, a cavity 101 is provided at a position, facing a first electrode 20, on a substrate 10, and the cavity 101 passes through the substrate 10, so that at least a part of a surface, away from a piezoelectric layer 30, of the first electrode 20 in an operation area of the resonator is in a suspended (or refer to be as hanging) state. In FIG. 19B, a difference between FIG. 19B and FIG. 19A lies in that, in FIG. 19B, a cavity 101 does not pass through a substrate 10, and a similarity to FIG. 19A lies in that at least a part of a surface, away from a piezoelectric layer 30, of a first electrode 20 in an operation area of the resonator is in a suspended (or refer to be as hanging) state.

Similar to the foregoing solid-state substrate piezoelectric thin-film resonator, in the suspended cavity piezoelectric thin-film resonator shown in FIG. 19A and FIG. 19B, a first groove 701 may also be provided in the piezoelectric layer 30, and there may also be a protective layer that covers a surface and a side surface of a second electrode 40 and covers a side surface and a bottom surface of the first groove 701.

In the suspended cavity piezoelectric thin-film resonator shown in FIG. 19A and FIG. 19B, as shown in FIG. 20, when a ratio of a pitch to a thickness of the piezoelectric layer increases, an electromechanical coupling factor increases correspondingly. For example, the electromechanical coupling factor may reach 42.75%. Further, in the suspended cavity piezoelectric thin-film resonator, the ratio of the pitch P to the thickness d of the piezoelectric layer meets: $1 \leq P/d$, or $1 \leq P/d \leq 30$, or $1 \leq P/d \leq 20$, or $1 \leq P/d \leq 10$. In this way, the resonator has a large electromechanical coupling factor.

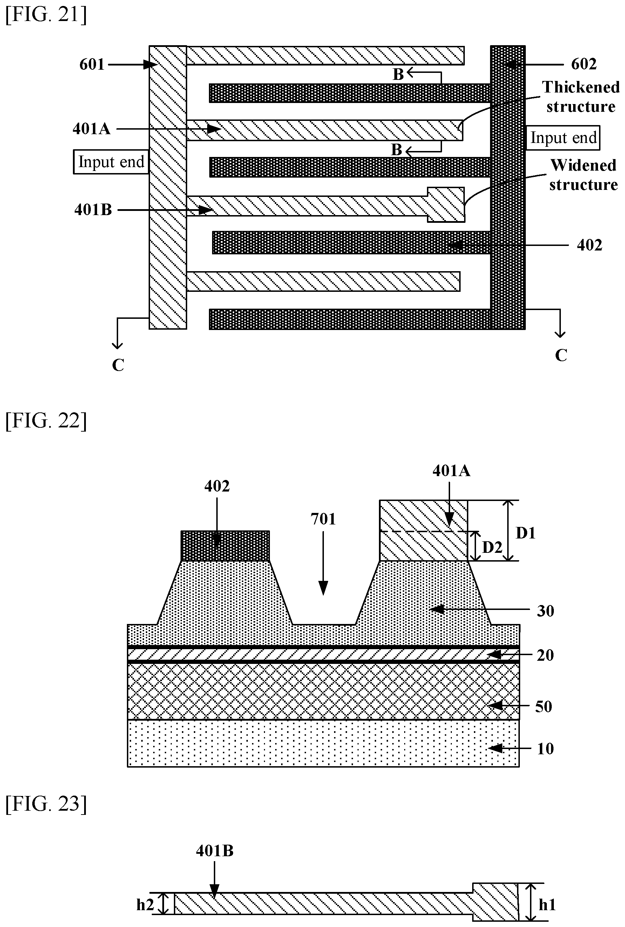

In either of the suspended cavity piezoelectric thin-film resonator and the solid-state substrate piezoelectric thin-film resonator in embodiments of this application, as shown in FIG. 21, an end portion, for electrically connecting to an input end, of a first interdigital electrode may be designed to be of a thickened structure or a widened structure. In this way, a transverse mode of the resonator can be suppressed, to further optimize operation performance of the resonator.

For example, refer to FIG. 21 and FIG. 22. FIG. 22 is a cross-sectional view obtained through cutting along a B-B direction in FIG. 21. In a first interdigital electrode 401A connected to a first busbar 601, a thickness dimension D1 of an end portion, away from the first busbar 601, of the first interdigital electrode 401A is greater than a thickness dimension D2 of a remaining part of the first interdigital electrode 401A, and $120\% \leq D1/D2 \leq 300\%$. For example, $D1/D2=150\%$, or $D1/D2=200\%$, or $D1/D2=250\%$.

For another example, further refer to FIG. 21 and FIG. 23. FIG. 23 is a detailed diagram of a first interdigital electrode 401B in FIG. 21. In the first interdigital electrode 401B connected to the first busbar 601, a width dimension h1 of an end portion, away from the first busbar 601, of the first interdigital electrode 401B is greater than a width dimension h2 of a remaining part of the first interdigital electrode 401B, and $100\% < h1/h2 \leq 200\%$. For example, $h1/h2=150\%$, or $h1/h2=180\%$. The width dimension herein is a dimension perpendicular to an extension direction of the first interdigital electrode 401B.

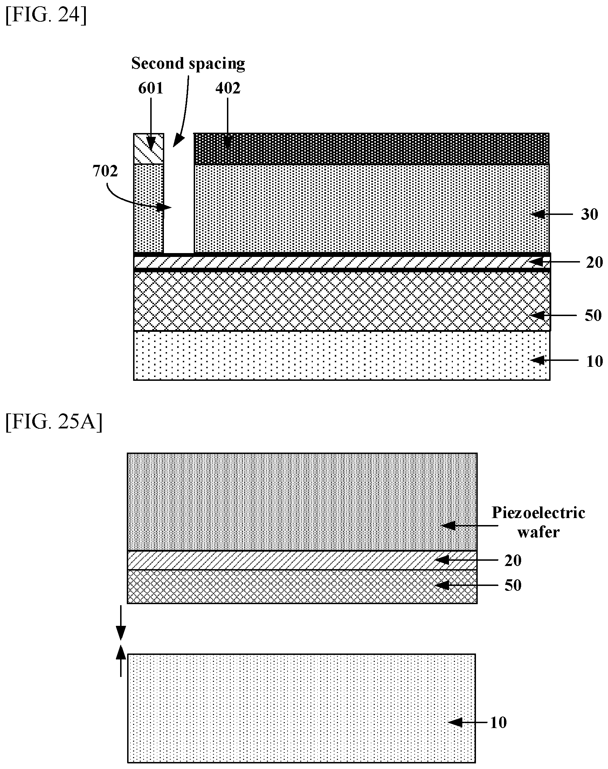

FIG. 24 is a cross-sectional view obtained through cutting along a C-C direction in FIG. 21. Refer to both FIG. 21 and FIG. 24. A second spacing is provided between a tip of a second electrode and a busbar, a second groove 702 is provided at a position, facing the second spacing, on a piezoelectric layer 30, and the second groove 702 communicates with the second spacing. For example, in FIG. 24, a second spacing is provided between a first busbar 601 and a tip, away from a second busbar 602, of a second interdigital electrode 402, and a part, facing the second spacing, of the piezoelectric layer 30 is also removed (for example, may be removed through etching). At least a part of the piezoelectric layer 30 in the area is removed, so that a transverse mode can be suppressed, to further optimize performance of the resonator.

An embodiment of this application further provides a preparation method for a resonator. The preparation method for a resonator includes:

preparing a first electrode, a piezoelectric layer, and a plurality of second electrodes, where the plurality of second electrodes are arranged side by side along a first direction, the piezoelectric layer is disposed between the first electrode and the plurality of second electrodes, and the first electrode is closer to a substrate than the plurality of second electrodes.

A crystal cutting angle and a propagation direction of a piezoelectric material of the piezoelectric layer are X-cut and a (120°±30°) Y propagation direction, and a Euler angle of a crystal of the piezoelectric material is (90°, 90°, 120°±30°); or a crystal cutting angle and a propagation direction of a piezoelectric material are Y-cut and a (90°±30°) X propagation direction, and a Euler angle of a crystal of the piezoelectric material is (0°, 90°, 90°±30°). An X direction of the piezoelectric material and a thickness direction of the piezoelectric layer are a same direction, and the (120°±30°) Y direction of the piezoelectric material and the first direction are a same direction; or a Y direction of the piezoelectric material and a thickness direction of the piezoelectric layer are a same direction, and the (90°±30°) X direction of the piezoelectric material and the first direction are a same direction.

A material of the first electrode may include any possible conductive metal (including but not limited to Be, Al, Cu, W, Mo, Ru, Pt, and the like). For example, metal (including but not limited to W, Ru, Mo, Pt, and the like) with high acoustic impedance may be selected. This helps increase an electromechanical coupling factor of a prepared resonator, and increase a quality factor Q of the resonator.

A material of the piezoelectric layer 30 includes at least one of lithium tantalate (LiTaO$_3$), lithium niobate (LiNbO$_3$), aluminum nitride (AlN), and zinc oxide (ZnO).

The following separately describes steps of preparation processes for a suspended cavity piezoelectric thin-film resonator and a solid-state substrate piezoelectric thin-film resonator.

FIG. 25A to FIG. 25C are diagrams of a process structure corresponding to each step of preparing a solid-state substrate piezoelectric thin-film resonator.

As shown in FIG. 25A, a first electrode 20 and a dielectric layer 50 are sequentially formed on one side of a piezoelectric wafer.

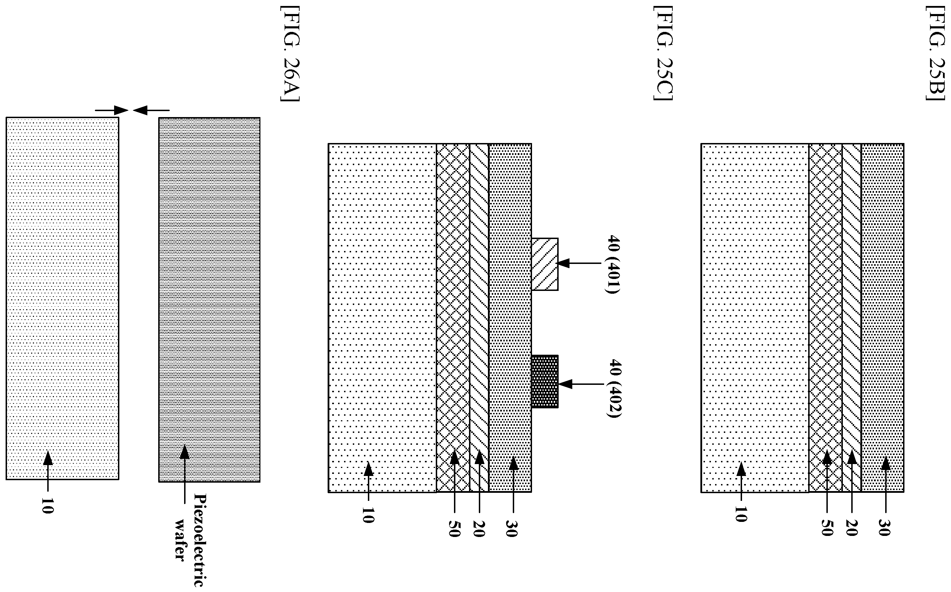

As shown in FIG. 25B, a piezoelectric wafer on which a first electrode 20 and a dielectric layer 50 are stacked is inverted, and is bonded to a substrate 10. In addition, the piezoelectric wafer may be thinned by using an ion implantation cutting (ion implantation cutting) or chemical-mechanical polishing (Chemical-mechanical polishing, CMP) method to reach a target thickness, to form a piezoelectric layer 30.

As shown in FIG. 25C, a plurality of second electrodes 40 arranged side by side are formed on a side, away from the first electrode 20, of the piezoelectric layer 30. In this way, a solid-state substrate piezoelectric thin-film resonator is prepared.

FIG. 25A to FIG. 25C show only some steps of a method for preparing a solid-state substrate piezoelectric thin-film resonator. In some other feasible process steps, when the step shown in FIG. 25A is performed, a Bragg reflection structure may alternatively be formed on one side of the substrate 10, and when the step shown in FIG. 25B is performed, the Bragg reflection structure is bonded to the dielectric layer 50. Alternatively, in some other feasible process steps, a groove may be provided in the piezoelectric layer 30. For example, a groove may be provided in the piezoelectric layer 30 through an etching process. The groove helps further suppress or frequency-shift a parasitic spurious mode, and increase an electromechanical coupling factor of the resonator. Alternatively, in some feasible process steps, a conductive connection layer may be formed between the dielectric layer 50 and the first electrode 20, to increase connection strength between film layers of the resonator.

During preparation of the plurality of second electrodes, a first busbar and a second busbar may be prepared, where the first busbar is connected to a plurality of first interdigital electrodes among the plurality of second electrodes, and the second busbar is connected to a plurality of second interdigital electrodes among the plurality of second electrodes.

In addition, an end portion of the second electrode may alternatively be thickened or widened.

FIG. 26A to FIG. 26E are diagrams of a process structure corresponding to each step of preparing a suspended cavity piezoelectric thin-film resonator.

In FIG. 26A, a piezoelectric wafer is bonded to a substrate 10. In some examples, there may alternatively be a dielectric layer between the piezoelectric wafer and the substrate 10.

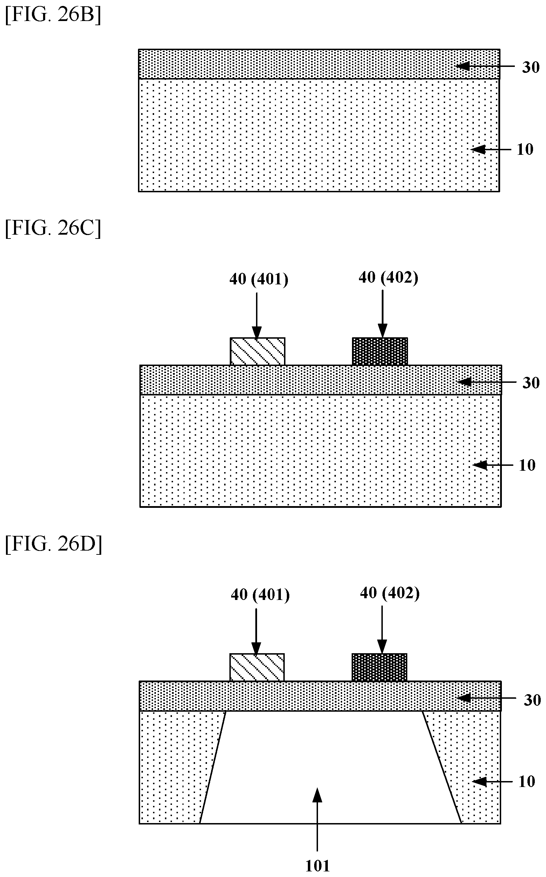

In FIG. 26B, the piezoelectric wafer may be thinned by using an ion implantation cutting (ion implantation cutting) or chemical-mechanical polishing (Chemical-mechanical polishing, CMP) method to reach a target thickness, to form a piezoelectric layer 30.

As shown in FIG. 26C, a plurality of second electrodes 40 arranged side by side are formed on a side, away from a first electrode 20, of the piezoelectric layer 30.

As shown in FIG. 26D, a cavity 101 is provided in the substrate 10, and the cavity 101 passes through the substrate 10 and extends to the piezoelectric layer 30. In addition, in this step, the cavity 101 needs to be provided below a resonance area in which the plurality of second electrodes 40 are located.

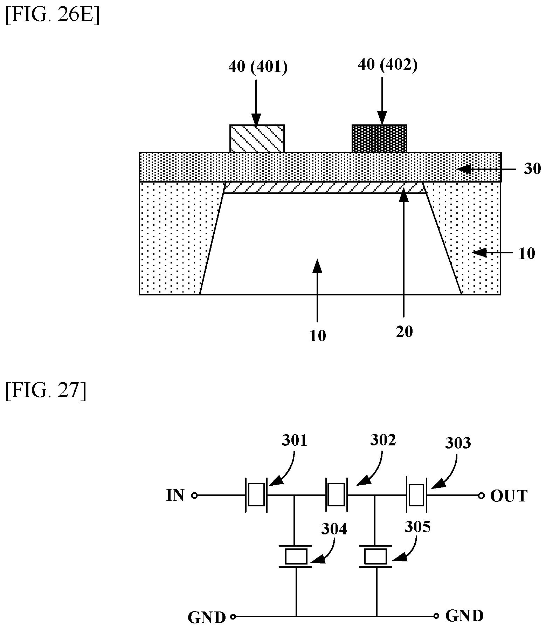

As shown in FIG. 26E, the first electrode 20 is formed on a bottom surface, close to the piezoelectric layer 30, of the cavity 101. In this way, a suspended cavity piezoelectric thin-film resonator is prepared.

Certainly, FIG. 26A to FIG. 26E show only some steps of a method for preparing a suspended cavity piezoelectric thin-film resonator. Some process steps may be further added. For example, a groove may be provided in the piezoelectric layer 30 through an etching process. The groove helps further suppress or frequency-shift a parasitic spurious mode, and increase an electromechanical coupling factor of the resonator. During preparation of the plurality of second electrodes, a first busbar and a second busbar may be prepared, where the first busbar is connected to a plurality of first interdigital electrodes among the plurality of second electrodes, and the second busbar is connected to a plurality of second interdigital electrodes among the plurality of second electrodes. An end portion of the second electrode may alternatively be thickened or widened. For example, the foregoing suspended cavity piezoelectric thin-film resonator or solid-state substrate piezoelectric thin-film resonator may serve as a sensor, for example, may be a temperature sensor, a humidity sensor, or a pressure sensor. Alternatively, the resonator may be used for processing of various high-frequency signals at 100 MHz to 30 GHz or the like as a delay-line device.

In addition, the foregoing suspended cavity piezoelectric thin-film resonator or solid-state substrate piezoelectric thin-film resonator may be electrically connected in a trapezoidal structure shown in FIG. 27, to implement a filter for radio frequency communication. The filter may include resonators connected in series and resonators connected in parallel. A resonance frequency of parallel resonators may be less than a resonance frequency of series resonators. For example, a thick piezoelectric layer 30, a thick protective layer 80, or a large pitch P in the foregoing resonator process structures can help reduce a resonance frequency of the resonators.

In an example in FIG. 27, a resonator 301, a resonator 302, a resonator 303, a resonator 304, and a resonator 305 are included. The resonator 301, the resonator 302, and the resonator 303 are series resonators, and the resonator 304 and the resonator 305 are parallel resonators. At least one of the resonator 301 to the resonator 305 may be the resonator in the foregoing embodiments.

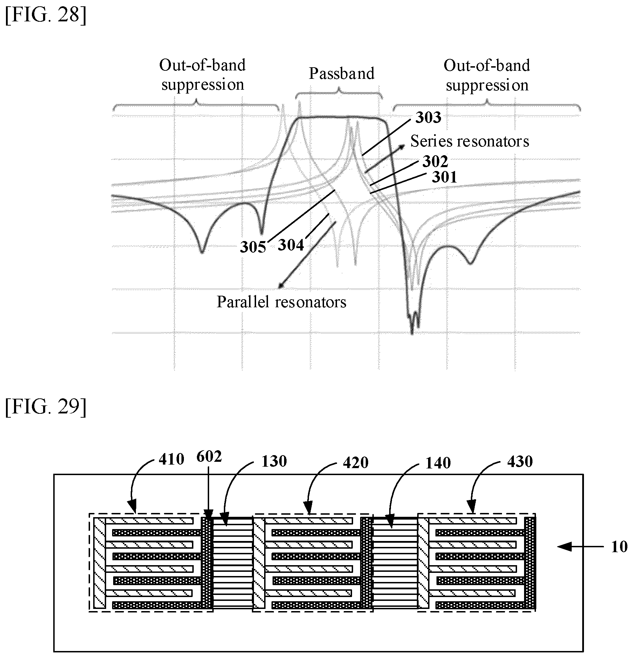

In some examples, FIG. 28 shows a relationship between an admittance curve of each resonator in a trapezoidal filter in FIG. 27 and a transmission loss curve of the filter. As shown in FIG. 28, a resonance point of the series resonators (for example, the resonator 301, the resonator 302, and the resonator 303) and an anti-resonance point of the parallel resonators (for example, the resonator 304 and the resonator 305) fall within a passband frequency band, to form a passband of the filter. An anti-resonance point of the series resonators (for example, the resonator 301, the resonator 302, and the resonator 303) falls on a high-frequency side beyond the passband, and a resonance point of the parallel resonators (for example, the resonator 304 and the resonator 305) falls on a low-frequency side beyond the passband. In this way, the filter is characterized by high roll-off and high out-of-band suppression.

In a filter, in a feasible process structure, a plurality of resonators provided in embodiments of this application may be integrated on one substrate 10. For example, as shown in FIG. 29, a resonator 410, a resonator 420, and a resonator 430 that are connected in series are integrated on a substrate 10, the resonator 410 and the resonator 420 are electrically connected through a conductive connection layer 130, and the resonator 420 and the resonator 430 are electrically connected through a conductive connection layer 140.

The conductive connection layer 130 or the conductive connection layer 140 has a plurality of feasible structures.

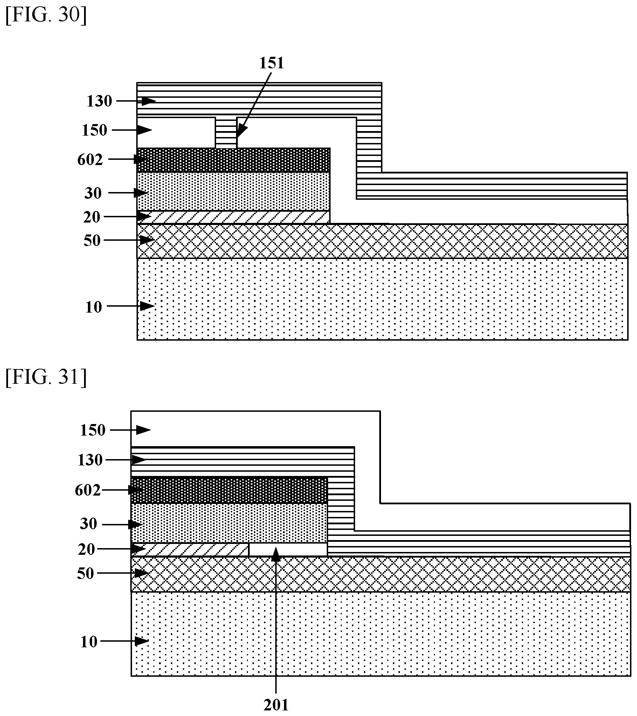

For example, FIG. 30 shows how to connect an acoustic resonator 410 to a conductive connection layer 130, and FIG. 30 shows a manner of disposing a conductive connection layer 130 in a solid-state substrate piezoelectric thin-film resonator. Specifically, as shown in FIG. 30, after a first electrode 20, a piezoelectric layer 30, and a second busbar 602 that are stacked are prepared, a dielectric layer 150 is formed on a side, away from a substrate 10, of the second busbar 602. The dielectric layer 150 is not only formed on one side of the second busbar 602, but also covers an area between two acoustic resonators. In addition, a hole 151 that passes through the dielectric layer 150 and extends to the second busbar 602 is provided in the dielectric layer 150 through etching. Then a conductive material is formed on a side, away from the second busbar 602, of the dielectric layer 150 and in the hole 151 of the dielectric layer 150, to form a conductive connection portion 130 electrically connected to the second busbar 602. In this way, the two acoustic resonators are electrically connected through the conductive connection layer 130.

For another example, FIG. 31 also shows how to connect an acoustic resonator 410 to a conductive connection layer 130, and FIG. 31 also shows a manner of disposing a conductive connection layer 130 in a solid-state substrate piezoelectric thin-film resonator. A difference between structures shown in FIG. 31 and FIG. 30 lies in: In FIG. 30, the conductive connection portion 130 is disposed farther away from the second busbar 602 than the dielectric layer 150. However, in FIG. 31, a conductive connection portion 130 is closer to a second busbar 602 than a dielectric layer 150. To be specific, in FIG. 31, the conductive connection portion 130 is stacked between the dielectric layer 150 and the second busbar 602, and is in direct contact with the second busbar 602 to implement an electrical connection.

In FIG. 31, to prevent an electrical connection between the conductive connection portion 130 and a first electrode 20, a gap 201 is formed at a position, close to the conductive connection portion 130, on the first electrode 20, to implement electrical isolation between the first electrode 20 and the conductive connection portion 130.

A material of the conductive connection layer (which may also be referred to as a pad layer) may be any conductive metal (including but not limited to Al, Cu, and the like).

In addition, as shown in FIG. 29, a dielectric layer 150 (including but not limited to $SiO_2$, SiN, polyimide, photoresist, and the like) is added between the second busbar 602 and the conductive connection layer (pad layer) 130, to avoid corresponding parasitic effect.

The filter in the foregoing embodiments of this application may be further used in a duplexer or a multiplexer. The duplexer includes a transmit-channel filter and a receive-channel filter. At least one of the transmit-channel filter and the receive-channel filter may perform filtering by using the foregoing filter. The multiplexer includes a plurality of transmit-channel filters and a plurality of receive-channel filters. At least one of the plurality of transmit-channel filters or at least one of the plurality of receive-channel filters may be the filter in embodiments of this application.

In the descriptions of this specification, specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1.  A resonator, comprising:

    a substrate; and
    a first electrode, a piezoelectric layer, and a plurality of second electrodes, wherein the plurality of second electrodes are arranged side by side along a first direction, the piezoelectric layer has a first side and a second side, the plurality of second electrodes are located on the first side, and the first electrode and the substrate are located on the second side, wherein
    the piezoelectric layer comprises a piezoelectric material; and
    a Euler angle of a crystal of the piezoelectric material is (90°, 90°, 120°±30°), or a crystal cutting angle and a propagation direction of the piezoelectric material are X-cut and a (120°±30°) Y propagation direction, wherein an X direction of the piezoelectric material and a thickness direction of the piezoelectric layer are a same direction, and the (120°±30°) Y direction of the piezoelectric material and the first direction are a same direction; or
    a Euler angle of a crystal of the piezoelectric material is (0°, 90°, 90°±30°), or a crystal cutting angle and a propagation direction of the piezoelectric material are Y-cut and a (90°±30°) X propagation direction, wherein a Y direction of the piezoelectric material and a thickness direction of the piezoelectric layer are a same direction, and the (90°±30°) X direction of the piezoelectric material and the first direction are a same direction.

2.  The resonator according to claim 1, wherein a first spacing is provided between two adjacent second electrodes; and a first groove is provided at a position, facing the first spacing, on the piezoelectric layer, and the first groove communicates with the first spacing.

3.  The resonator according to claim 2, wherein the piezoelectric layer has a bottom surface located on the second side and a top surface located on the first side, and the first groove communicates with the bottom surface and the top surface.

4.  The resonator according to any one of claims 1 to 3, wherein the first electrode has a first surface and a second surface that are opposite to each other, and the first surface is closer to the piezoelectric layer than the second surface; and the substrate is provided with a cavity, at least a part of the second surface of the first electrode is used to enclose the cavity, and at least a part of the first electrode is disposed between the cavity and the piezoelectric layer.

5.  The resonator according to claim 4, wherein an electromechanical coupling factor $K_t^2$ of the resonator is greater than or equal to 20%.

6.  The resonator according to claim 4 or 5, wherein the resonator further comprises a first busbar and a second busbar;

    one of every two adjacent second electrodes among the plurality of second electrodes is a first interdigital electrode, and the other is a second interdigital electrode, wherein the first interdigital electrode and the second interdigital electrode are spaced apart along the first direction, and an extension direction of the first interdigital electrode and/or an extension direction of the second interdigital electrode are/is perpendicular to the first direction;
    a plurality of first interdigital electrodes among the plurality of second electrodes are connected through the first busbar, and a plurality of second interdigital electrodes among the plurality of second electrodes are connected through the second busbar;
    a pitch P and a thickness d of the piezoelectric layer meet: P/d≥0.5; and
    a width dimension of each first interdigital electrode is s1, a spacing between each first interdigital electrode and each second interdigital electrode that are adjacent to each other is s2, the pitch P is equal to s1+s2, and the width dimension is a dimension parallel to a surface of the substrate and perpendicular to the extension direction of the first interdigital electrode.

7. The resonator according to any one of claims 1 to 3, wherein the first electrode has a first surface and a second surface that are opposite to each other, and the first surface is closer to the piezoelectric layer than the second surface; and the first electrode is disposed between the substrate and the piezoelectric layer, and the second surface of the first electrode is completely provided on the substrate.

8. The resonator according to claim 7, wherein an electromechanical coupling factor $K_t^2$ of the resonator is greater than or equal to 10%.

9. The resonator according to claim 7 or 8, wherein the resonator further comprises a first busbar and a second busbar;

one of every two adjacent second electrodes among the plurality of second electrodes is a first interdigital electrode, and the other is a second interdigital electrode, wherein the first interdigital electrode and the second interdigital electrode are spaced apart along the first direction, and an extension direction of the first interdigital electrode and/or an extension direction of the second interdigital electrode are/is perpendicular to the first direction;
a plurality of first interdigital electrodes among the plurality of second electrodes are connected through the first busbar, and a plurality of second interdigital electrodes among the plurality of second electrodes are connected through the second busbar;
a pitch P meets: $P < \dfrac{Vs}{2f}$, wherein Vs is a shear bulk acoustic wave velocity of the substrate, and f is an operating frequency of the resonator; and
a width dimension of each first interdigital electrode is s1, a spacing between each first interdigital electrode and each second interdigital electrode that are adjacent to each other is s2, the pitch P is equal to s1+s2, and the width dimension is a dimension parallel to a surface of the substrate and perpendicular to the extension direction of the first interdigital electrode.

10. The resonator according to claim 9, wherein the substrate comprises at least one of silicon carbide, boron nitride, and diamond.

11. The resonator according to claim 9 or 10, wherein a thickness dimension Z of the substrate meets: Z≥4d, wherein d is a thickness dimension of the piezoelectric layer, and both the thickness dimension of the substrate and the thickness dimension of the piezoelectric layer are dimensions along a direction perpendicular to the surface of the substrate.

12. The resonator according to claim 7 or 8, wherein the resonator further comprises:

a first reflection layer and a second reflection layer that are stacked, wherein
the first reflection layer and the second reflection layer are disposed between the substrate and the first electrode;
a thickness t1 of the first reflection layer meets: $\dfrac{1}{8}\lambda_1 \leq t1 \leq \dfrac{3}{8}\lambda_1$ ; and
a thickness t2 of the second reflection layer meets: $\dfrac{1}{8}\lambda_2 \leq t2 \leq \dfrac{3}{8}\lambda_2$ , wherein
$\lambda_1$ is a wavelength of an acoustic wave of the resonator at a resonance frequency in a material of the first reflection layer; and
$\lambda_2$ is a wavelength of the acoustic wave in a material of the second reflection layer.

13. The resonator according to any one of claims 7 to 12, wherein a dielectric layer is stacked between the substrate and the first electrode, and a thickness g of the dielectric layer meets: g=λ/4, wherein λ is a wavelength of the acoustic wave of the resonator at the resonance frequency in a material of the dielectric layer.

14. The resonator according to any one of claims 7 to 13, wherein the resonator further comprises a first busbar and a second busbar;

one of every two adjacent second electrodes among the plurality of second electrodes is a first interdigital electrode, and the other is a second interdigital electrode, wherein the first interdigital electrode and the second interdigital electrode are spaced apart along the first direction, and an extension direction of the first interdigital electrode and/or an extension direction of the second interdigital electrode are/is perpendicular to the first direction;

a plurality of first interdigital electrodes among the plurality of second electrodes are connected through the first busbar, and a plurality of second interdigital electrodes among the plurality of second electrodes are connected through the second busbar;

a pitch P and a thickness d of the piezoelectric layer meet: $P/d \geq 1$; and a width dimension of each first interdigital electrode is s1, a spacing between each first interdigital electrode and each second interdigital electrode that are adjacent to each other is s2, the pitch P is equal to s1+s2, and the width dimension is a dimension parallel to a surface of the substrate and perpendicular to the extension direction of the first interdigital electrode.

15. The resonator according to any one of claims 1 to 14, wherein the resonator further comprises a conductive connection layer; and

the conductive connection layer is stacked between the first electrode and the piezoelectric layer.

16. The resonator according to any one of claims 1 to 15, wherein at least a part of the plurality of second electrodes comprise a first end portion and a second end portion, and a thickness dimension D1 of the first end portion and a thickness dimension D2 of the second end portion meet:

$$120\% \leq D1/D2 \leq 300\%.$$

17. The resonator according to any one of claims 1 to 16, wherein at least a part of the plurality of second electrodes comprise a first end portion and a second end portion, and a width dimension h1 of the first end portion and a width dimension h2 of the second end portion meet: $100\% < h1/h2 \leq 200\%$, wherein the width dimension is a dimension parallel to the surface of the substrate and perpendicular to an extension direction of the second electrodes.

18. The resonator according to any one of claims 1 to 17, wherein the resonator further comprises a first busbar and a second busbar;

one of every two adjacent second electrodes among the plurality of second electrodes is a first interdigital electrode, and the other is a second interdigital electrode, wherein the first interdigital electrode and the second interdigital electrode are spaced apart along the first direction, and an extension direction of the first interdigital electrode and/or an extension direction of the second interdigital electrode are/is perpendicular to the first direction;

a plurality of first interdigital electrodes among the plurality of second electrodes are connected through the first busbar, and a plurality of second interdigital electrodes among the plurality of second electrodes are connected through the second busbar;

an end portion, connected to the first busbar, of the first interdigital electrode is an electrode connection end, the other end is an electrode tip, and a second spacing is provided between the electrode tip and the second busbar; and

a second groove is provided at a position, facing the second spacing, on the piezoelectric layer, and the second groove communicates with the second spacing.

19. The resonator according to any one of claims 1 to 18, wherein the resonator further comprises a plurality of gratings arranged in parallel, the plurality of gratings are connected through a first connection strip at one end, the plurality of gratings are connected through a second connection strip at the other end, and an extension direction of the gratings is the same as the extension direction of the second electrodes; one of every two adjacent second electrodes among the plurality of second electrodes is a first interdigital electrode, and the other is a second interdigital electrode, wherein the first interdigital electrode and the second interdigital electrode are spaced apart along the first direction, an extension direction of the first interdigital electrode and/or an extension direction of the second interdigital electrode are/is perpendicular to the first direction, a plurality of first interdigital electrodes among the plurality of second electrodes are connected through the first busbar, and a plurality of second interdigital electrodes among the plurality of second electrodes are connected through the second busbar; and

a spacing t between two adjacent gratings meets: $0.3 \leq t/P \leq 0.7$, wherein P is a pitch, a width dimension of each first interdigital electrode is s1, a spacing between each first interdigital electrode and each second interdigital electrode that are adjacent to each other is s2, the pitch P is equal to s1+s2, and the width dimension is a dimension parallel to a surface of the substrate and perpendicular to the extension direction of the first interdigital electrode.

**20.** The resonator according to any one of claims 1 to 19, wherein the piezoelectric layer comprises a first side wall and a second side wall that are opposite to each other; and
the first side wall and/or the second side wall are/is a plane perpendicular to the surface of the substrate and parallel to the extension direction of the second electrodes.

**21.** The resonator according to any one of claims 1 to 20, wherein a material of the piezoelectric layer comprises at least one of the following combinations: a combination of niobium and lithium, and a combination of tantalum and lithium; and
a material of the first electrode comprises at least one of tungsten, platinum, molybdenum, and aluminum.

**22.** The resonator according to any one of claims 1 to 21, wherein the piezoelectric material has a plurality of electromechanical coupling factor components, and a value of an electromechanical coupling factor component $k_{35}^2$ is the largest one of values of the plurality of electromechanical coupling factor components.

**23.** The resonator according to claim 22, wherein the electromechanical coupling factor component $k_{35}^2$ meets: $0.4 < k_{35}^2$.

**24.** The resonator according to claim 22 or 23, wherein the electromechanical coupling factor component $k_{35}^2$ meets:

$$0.4 < k_{35}^2 < 0.95.$$

**25.** The resonator according to any one of claims 22 to 24, wherein
based on a voltage being applied to the plurality of second electrodes, the resonator is configured to generate a first-order anti-symmetry mode when exciting the electromechanical coupling factor component $k_{35}^2$ of the piezoelectric material, wherein a vibration direction of the first-order anti-symmetry mode is parallel to the surface of the substrate and perpendicular to the extension direction of the second electrodes.

**26.** The resonator according to claim 25, wherein

an electric field used by the resonator to excite at least a part of electromechanical coupling factor components other than the electromechanical coupling factor component $k_{35}^2$ is parallel to the extension direction of the second electrodes, wherein
the at least a part of electromechanical coupling factor components comprise at least one of electromechanical coupling factor components $k_{21}^2$, $k_{22}^2$, $k_{23}^2$, $k_{24}^2$, $k_{25}^2$, and $k_{26}^2$.

**27.** A resonator, comprising:

a substrate; and
a first electrode, a piezoelectric layer, and a plurality of second electrodes, wherein the plurality of second electrodes are arranged side by side, the piezoelectric layer has a first side and a second side, the plurality of second electrodes are located on the first side, and the first electrode and the substrate are located on the second side, wherein
the piezoelectric layer comprises a piezoelectric material, and a value of an electromechanical coupling factor component $k_{35}^2$ of the piezoelectric material meets: $k_{35}^2 > 0.4$.

**28.** The resonator according to claim 27, wherein the piezoelectric material has a plurality of electromechanical coupling factor components, and a value of the electromechanical coupling factor component $k_{35}^2$ is the largest one of values of the plurality of electromechanical coupling factor components.

**29.** The resonator according to claim 28, wherein the electromechanical coupling factor component $k_{35}^2$ meets: $0.4 < k_{35}^2$.

**30.** The resonator according to claim 28 or 29, wherein the value of the electromechanical coupling factor component $k_{35}^2$ meets:

$$0.4 < k_{35}^2 < 0.95.$$

**31.** The resonator according to any one of claims 27 to 30, wherein

based on a voltage being applied to the plurality of second electrodes, the resonator is configured to generate a first-order anti-symmetry mode when exciting the electromechanical coupling factor component $k_{35}^2$ of the piezoelectric material, wherein a vibration direction of the first-order anti-symmetry mode is parallel to a surface of the substrate and perpendicular to an extension direction of the second electrodes.

32. The resonator according to claim 31, wherein

an electric field used by the resonator to excite at least a part of electromechanical coupling factor components other than the electromechanical coupling factor component $k_{35}^2$ is parallel to the extension direction of the second electrodes, wherein
the at least a part of electromechanical coupling factor components comprise at least one of electromechanical coupling factor components $k_{21}^2$, $k_{22}^2$, $k_{23}^2$, $k_{24}^2$, $k_{25}^2$, and $k_{26}^2$.

33. A filter, comprising:
a plurality of electrically connected resonators, wherein at least one of the plurality of resonators is the resonator according to any one of claims 1 to 32.

34. An electronic device, comprising:

a control circuit; and
the resonator according to any one of claims 1 to 32, or the filter according to claim 33, wherein the resonator or the filter is electrically connected to the control circuit.

[FIG. 1]

Electronic device 100

Filter 200

Resonator 300

[FIG. 2]

[FIG. 3]

Filter 200

Resonator 300

[FIG. 4]

[FIG. 5A]

SH1 mode (a vibration
direction is the direction 2)

[FIG. 5B]

First surface

Second surface

E

40
30
20
50
10

3
2
1

**SH1 mode (a vibration direction is the direction 2)**

[FIG. 6A]

[FIG. 6B]

S0 longitudinal wave
mode (spurious mode)
Vibration direction 1 ($k_{11}^2$)

SH1 mode (main resonance mode)
Vibration direction 2 ($k_{34}^2$)

A1 mode (spurious mode)
Vibration direction 1 ($k_{35}^2$)

Main
mode

Spurious
mode

Spurious mode

p=1 μm
p=1.05 μm
p=1.1 μm
p=1.15 μm
p=1.2 μm
p=1.25 μm

freq (Hz)

EP 4 637 031 A1

[FIG. 7A]

**First direction**

P

X

(120°±30°) Y

40

30

20

50

10

3

2

1

**SH1 mode (a vibration
direction is the direction 2)**

[FIG. 7B]

**First direction**

P

Y

(90°±30°) X

40

30

20

50

10

3

2

1

**SH1 mode (a vibration
direction is the direction 2)**

[FIG. 8A]

[FIG. 8B]

SH1 mode
Vibration direction 2 ($k_{34}^2$)

S0 longitudinal-wave spurious mode Vibration direction 1 ($k_{11}^2$)

abs(Y11)

Third-order SV spurious mode Vibration direction 3 ($k_{16}^2$)

A1 spurious mode Vibration direction 1 ($k_{35}^2$)

abs(Y11)
Re(Y11)

Re(Y11)

freq (Hz)

EP 4 637 031 A1

[FIG. 9]

First direction

**401**　　　**402**　　　**401**　　　**402**

L

Thickness of a
piezoelectric layer

Thickness of a
first electrode

30

20

10

3
2
1

[FIG. 10]

**601**　　**401**　　**402**　　s2　s1　　**602**

Pitch

Pitch

First
direction

1
3
2

[FIG. 11A]

EP 4 637 031 A1

[FIG. 11B]

[FIG. 12]

**First spacing**

40 (401)　　701　　40 (402)

H　h　α　　α

30

60b
20
60a
50
10

[FIG. 13]

40 (401)　　701　　40 (402)

Top surface

Bottom surface

30

α　　α

60b
20
60a
50
10

[FIG. 14]

[FIG. 15]

[FIG. 16]

[FIG. 17]

[FIG. 18]

Side
wall

40
(401)

40
(402)

40
(401)

40
(402)

40
(401)

40
(402)

40
(401)

40
(402)

Side
wall

30

20

50

10

[FIG. 19A]

40 (401)

40 (402)

701

30

20

10

101

[FIG. 19B]

**40 (401)**          **40 (402)**

**701**

**30**

**20**

**10**

**101**

[FIG. 20]

Electromechanical
coupling factor

**Pitch/Thickness of a
piezoelectric layer**

[FIG. 21]

[FIG. 22]

[FIG. 23]

[FIG. 24]

Second spacing

601 402

702

30

20

50

10

[FIG. 25A]

Piezoelectric wafer

20

50

10

[FIG. 25B]

30
20
50

10

[FIG. 25C]

40 (401)    40 (402)

30
20
50

10

[FIG. 26A]

Piezoelectric
wafer

10

[FIG. 26B]

30

10

[FIG. 26C]

40 (401)    40 (402)

30

10

[FIG. 26D]

40 (401)    40 (402)

30

10

101

[FIG. 26E]

**40 (401)**  **40 (402)**

30

10

**10**  **20**

[FIG. 27]

301  302  303

IN o——OUT

**304**  **305**

GND o——o GND

[FIG. 28]

[FIG. 29]

[FIG. 30]

130
150
602
30
20
50

151

10

[FIG. 31]

150
130
602
30
20
50

10

201

## INTERNATIONAL SEARCH REPORT

| International application No. |
| --- |
| **PCT/CN2023/133797** |

**A. CLASSIFICATION OF SUBJECT MATTER**

H03H9/17(2006.01)i

According to International Patent Classification (IPC) or to both national classification and IPC

**B. FIELDS SEARCHED**

Minimum documentation searched (classification system followed by classification symbols)

IPC: H03H

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 谐振器, 滤波器, 电极, 压电层, 衬底, 晶体, 欧拉角, 切割角, 传播方向, 沟槽, resonator, wave filter, electrode, euler angle, cutting angle

**C. DOCUMENTS CONSIDERED TO BE RELEVANT**

| Category* | Citation of document, with indication, where appropriate, of the relevant passages | Relevant to claim No. |
| --- | --- | --- |
| A | CN 115395918 A (UNIVERSITY OF SCIENCE AND TECHNOLOGY OF CHINA) 25 November 2022 (2022-11-25) description, paragraphs [0011]-[0068], and figure 1 | 1-34 |
| A | CN 114221633 A (UNIVERSITY OF SCIENCE AND TECHNOLOGY OF CHINA) 22 March 2022 (2022-03-22) entire document | 1-34 |
| A | CN 113708739 A (SHANGHAI INSTITUTE OF MICROSYSTEM AND INFORMATION TECHNOLOGY, CHINESE ACADEMY OF SCIENCES) 26 November 2021 (2021-11-26) entire document | 1-34 |
| A | JP 2010157956 A (PANASONIC CORP.) 15 July 2010 (2010-07-15) entire document | 1-34 |

☐ Further documents are listed in the continuation of Box C.  ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **04 February 2024** | **07 February 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
|---|
| **PCT/CN2023/133797** |

| Patent document cited in search report | | | Publication date (day/month/year) | Patent family member(s) | Publication date (day/month/year) |
|---|---|---|---|---|---|
| CN | 115395918 | A | 25 November 2022 | None | |
| CN | 114221633 | A | 22 March 2022 | None | |
| CN | 113708739 | A | 26 November 2021 | None | |
| JP | 2010157956 | A | 15 July 2010 | None | |

Form PCT/ISA/210 (patent family annex) (July 2022)

**REFERENCES CITED IN THE DESCRIPTION**

**Patent documents cited in the description**

- CN 202310202885
- CN 202310490983
- CN 202310639000